(19) Europäisches Patentamt
European Patent Office
Office européen des brevets

(11) EP 3 284 771 B1

(12) **EUROPEAN PATENT SPECIFICATION**

(45) Date of publication and mention of the grant of the patent:
**30.08.2023 Bulletin 2023/35**

(21) Application number: **16779830.5**

(22) Date of filing: **02.03.2016**

(51) International Patent Classification (IPC):
***C08G 73/06*** (2006.01) ***C08L 79/08*** (2006.01)
***C08J 5/18*** (2006.01) ***C09D 179/04*** (2006.01)
***C09D 179/08*** (2006.01) ***C08G 73/10*** (2006.01)
***C08G 73/22*** (2006.01) ***C09D 7/20*** (2018.01)
***H01L 23/29*** (2006.01) ***H01L 23/31*** (2006.01)
***H01L 23/495*** (2006.01) ***H01L 23/522*** (2006.01)
*H01L 21/02* (2006.01)

(52) Cooperative Patent Classification (CPC):
(C-Sets available)
**C08G 73/06; C08G 73/1007; C08G 73/22; C08L 79/08; C09D 7/20; C09D 179/04; C09D 179/08; H01L 21/02118; H01L 21/02282; H01L 23/293; H01L 23/4951; H01L 23/49513; H01L 23/5227;** H01L 23/3107; H01L 28/10; (Cont.)

(86) International application number:
**PCT/JP2016/056349**

(87) International publication number:
**WO 2016/167038 (20.10.2016 Gazette 2016/42)**

(54) **HEAT-RESISTANT RESIN COMPOSITION, METHOD FOR MANUFACTURING HEAT-RESISTANT RESIN FILM, METHOD FOR MANUFACTURING INTERLAYER INSULATION FILM OR SURFACE PROTECTIVE FILM, AND METHOD FOR MANUFACTURING ELECTRONIC COMPONENT OR SEMICONDUCTOR COMPONENT**

HITZEBESTÄNDIGE HARZZUSAMMENSETZUNG, VERFAHREN ZUR HERSTELLUNG EINES HITZEBESTÄNDIGEN HARZFILMS, VERFAHREN ZUR HERSTELLUNG EINES ZWISCHENSCHICHTISOLATIONSFILMS ODER EINES OBERFLÄCHENSCHUTZFILMS SOWIE VERFAHREN ZUR HERSTELLUNG EINER ELEKTRONISCHEN KOMPONENTE ODER EINES HALBLEITERBAUELEMENTS

COMPOSITION DE RÉSINE RÉSISTANT À LA CHALEUR, PROCÉDÉ DE FABRICATION D’UN FILM DE RÉSINE RÉSISTANT À LA CHALEUR, PROCÉDÉ DE FABRICATION D’UN FILM D’ISOLATION INTERCOUCHE OU D’UN FILM PROTECTEUR DE SURFACE ET PROCÉDÉ DE FABRICATION DE COMPOSANT ÉLECTRONIQUE OU DE COMPOSANT SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.04.2015 JP 2015083049**

(43) Date of publication of application:
**21.02.2018 Bulletin 2018/08**

(73) Proprietor: **Toray Industries, Inc.**
**Tokyo 103-8666 (JP)**

(72) Inventors:
- **KIUCHI, Yohei**
**Otsu-shi**
**Shiga 520-8558 (JP)**
- **OKUDA, Ryoji**
**Otsu-shi**
**Shiga 520-8558 (JP)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(74) Representative: **Hoefer & Partner Patentanwälte mbB**
**Pilgersheimer Straße 20**
**81543 München (DE)**

(56) References cited:

| | |
|---|---|
| **WO-A1-01/68742** | **WO-A1-2009/038205** |
| **WO-A1-2012/090827** | **JP-A- 2002 327 060** |
| **JP-A- 2005 239 862** | **JP-A- 2007 211 136** |
| **JP-A- 2010 155 895** | **JP-A- 2012 180 471** |
| **JP-A- 2013 166 925** | **JP-A- 2013 216 776** |
| **JP-A- 2014 118 532** | **JP-A- 2014 132 057** |

(52) Cooperative Patent Classification (CPC): (Cont.)
H01L 2224/4826; H01L 2924/181

C-Sets
H01L 2924/181, H01L 2924/00012

## Description

TECHNICAL FIELD

The present invention relates to a heat-resistant resin composition, a method for manufacturing a heat-resistant resin film, a method for manufacturing an interlayer insulation film or a surface protective film, and a method for manufacturing an electronic component or a semiconductor component. More specifically, the invention relates to a heat-resistant resin composition suited for applications such as a surface protective film and rewiring insulation film of a semiconductor element, an interlayer insulation film of a thin film inductor, an insulation film of an organic electroluminescence (hereinafter referred to as EL) element, a flattening film of a thin film transistor (hereinafter referred to as TFT) substrate for driving a display device including an organic EL element, a wire protective insulation film of a circuit board, an on-chip microlens of a solid imaging element, and a flattening film for various displays and solid imaging elements, and a

method for manufacturing a heat-resistant resin film.

BACKGROUND ART

Resins typified by polyimide and polybenzoxazole have their excellent heat resistance, or electrical insulation property or the like, and are used for a surface protective film of a semiconductor element or the like, an interlayer insulation film of a thin film inductor, an insulating layer of an organic EL element, a flattening film of a TFT substrate, and the like.

In recent years, an electronic component referred to as a thin film inductor has been attracting attention. The thin film inductor has a spiral thin film coil structure formed by repetitively performing steps such as photolithography and plating on a substrate, and is mainly used in a common mode filter application or the like for mobile devices such as a wearable device, a smart phone, a tablet terminal, and a digital camera.

Particularly, the high function and multiple functions of an electronic device typified by smartphone cause an increase in the number of components, so that a space per component is decreased, and reduction in size and thickness of the component has been required. A thin film inductor allowing saving space is required for such a product.

Conventionally, a semi-additive method has been adopted for forming such a coil pattern. After a coil pattern is completed through photolithography and plating steps, a polyimide heat-resistant resin composition is formed into an interlayer insulation film, and the above steps are further repeated in the case of a laminated coil structure.

Examples of the step of applying the heat-resistant resin composition include application through a spin coating method, application through a spray method, application through a slit coating method, and application through an inkjet method. In the application of an electronic component, application through a spin coating method is general (for example, see Patent Documents 1 to 4).

Patent Document 5 teaches a polybenzoxazol having a low permittivity, a low coefficient of linear thermal expansion, a very high solder heat resistance, and also a good toughness, which useful as an insulator of electronic parts.

Patent Document 6 discloses a polyimide complex that emits fluorescence having a specific wavelength and achieves high fluorescence intensity as a result of being irradiated with ultraviolet rays without compromising the colorless transparency, mechanical properties, and heat resistance of a polyimide having a specific structure, and to provide a method for manufacturing the complex. This polyimide complex is obtained by adding 0.001-4 parts by weight of a europium (Eu) compound per 100 parts by weight of a polyamic acid solution (S1) obtained from a specific polyamic acid obtained from an alicyclic diamine compound (A) and an aromatic tetracarboxylic dianhydride (B) as well as a solvent (C) in which the polyamic acid dissolves, obtaining a polyamic acid solution (S2), and imidating the polyamic acid contained in the polyamic acid solution (S2) and removing the solvent (C).

Patent Document 7 teaches a composition capable of obtaining a coated film having advantageous viscosity stability and advantageous fluidity during the processing, having advantageous shape retentivity after the processing, having advantageous drying property in a temperature range in which a conductive layer is not degraded during the drying, and being excellent in the adhesion strength with a metal-polyimide, flame retardancy, heat resistance, flexibility, mechanical physical property, and chemicals resistance after the drying. This composition is a composition comprising (A) a polyimide and (B) a solvent mixture of two or more types of solvents, in which the compatibilization parameter of the solvent mixture of two or more types of solvents is 9 to 14.

Patent Document 8 teaches a polyimide porous film or a coating having excellent heat resistance, excellent chemical resistance and a high porosity. Provided is a polyimide porous film in which a solvent mixture of an amide solvent and an ether solvent whose mutual boiling points are in a specific relationship is used for a solvent of a polyimide precursor, so that the film is made porous upon imidization under heat, and the film has a density of 0.10-0.60 g/cm and a maximum pore diameter of not more than 1 mm and also includes a compact layer on the surface.

Patent Document 9 relates to a process for producing a polyimide film, which comprises applying a polyamic acid

solution composition to a base material to form a coating film, and subsequently heating the coating film, wherein the polyamic acid solution composition comprises a mixed solvent of two or more solvents selected from N-methyl-2-pyrrolidone, N-ethyl-2-pyrrolidone and 1,3-dimethyl-2-imidazolidinone (wherein each of the solvents is contained in an amount of 7 to 93 mass% relative to 100 mass% of the total amount of the solvents) and a polyamic acid mainly composed of s-BPDA and PPD. The process enables to produce a polyimide film having a film thickness of more than 40 μm without the need of expanding the film.

PRIOR ART DOCUMENT

PATENT DOCUMENTS

Patent Document 1: Japanese Patent Application Laid-Open No. 2008-186990
Patent Document 2: WO 2010/047264
Patent Document 3: WO 2011/0300744
Patent Document 4: Japanese Patent Application Laid-Open No. 2014-162818
Patent Document 5: JP 2002-327060 A
Patent Document 6: WO 2012/090827 A1
Patent Document 7: JP 2010-155895 A
Patent Document 8: JP 2014-132057 A
Patent Document 9: WO 2009-038205 A1

SUMMARY OF THE INVENTION

PROBLEMS TO BE SOLVED BY THE INVENTION

However, when a heat-resistant resin composition is applied on a narrow pitch and high aspect coil pattern which has been seen in recent years, the heat-resistant resin composition is insufficiently applied to or covers step parts in the coil pattern, and therefore the flatness of the surface of the coil pattern may be deteriorated. As a result, the problem arises that the processing accuracy of the coil pattern is largely deteriorated in the upper layer of the laminated coil structure. Therefore, there is a demand for a heat-resistant resin composition which can cover step parts of the coil pattern, can provide a flat surface, and has excellent step embedding properties.

Accordingly, an object of the present invention is to provide a heat-resistant resin composition having excellent step embedding properties on a support substrate such as a coil pattern.

SOLUTIONS TO THE PROBLEMS

In order to achieve the above object, a heat-resistant resin composition according to the present invention has the following constitutions. That is, (1) a heat-resistant resin composition containing at least one resin selected from the group consisting of a polyimide, a polybenzoxazole, a polyimide precursor, and a polybenzoxazole precursor as a resin (A) ; an organic solvent having a boiling point of 210°C or higher and 260°C or lower at atmospheric pressure as an organic solvent (B) ; and an organic solvent having a boiling point of 100°C or higher and lower than 210°C at atmospheric pressure as an organic solvent (C), wherein a content of the organic solvent (B) is 5% by mass or more and 70% by mass or less with respect to the whole amount of the organic solvents; and a content of the organic solvent (C) is 30% by mass or more and 95% by mass or less with respect to the whole amount of the organic solvents, and wherein the organic solvent (C) contains an organic solvent having a boiling point of 140°C or higher and lower than 210°C at atmospheric pressure as an organic solvent (C-1), and an organic solvent having a boiling point of 100°C or higher and lower than 140°C at atmospheric pressure as an organic solvent (C-2); and a ratio of a content of the organic solvent (C-1) to a content of the organic solvent (C-2) is 1 : 9 to 9 : 1 by mass ratio.

(2) The heat-resistant resin composition according to the above (1), wherein the organic solvent (B), the organic solvent (C-1), and the organic solvent (C-2) each have a solubility parameter of 7.0 or more and 13.0 or less.

(3) The heat-resistant resin composition according to the above (1) or (2), wherein the organic solvent (B) contains at least one organic solvent selected from the group consisting of an organic solvent represented by general formula (1) below, an organic solvent represented by general formula (2) below, and an organic solvent represented by general formula (3) below:

[Chemical Formula 1]

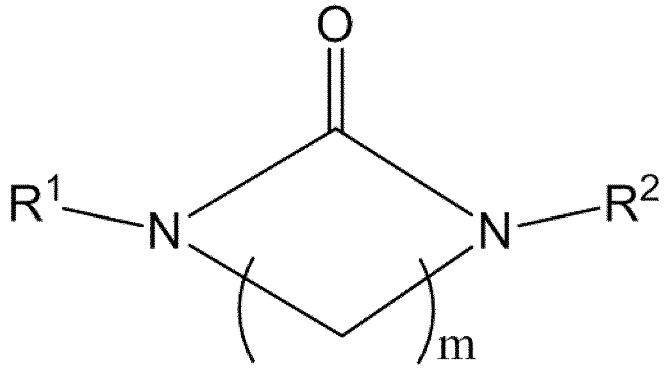

(1)

wherein $R^1$ and $R^2$ may be the same or different from each other, and each represent a monovalent organic group having 1 to 10 carbon atoms; and m represents an integer of 1 to 5;

[Chemical Formula 2]

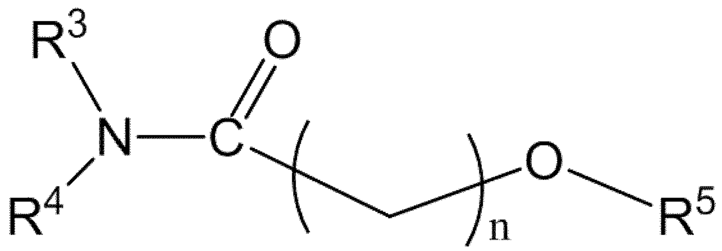

(2)

wherein $R^3$, $R^4$ and $R^5$ may be the same or different from one another, and each represent a monovalent organic group having 1 to 10 carbon atoms; and n represents an integer of 1 to 10; and

[Chemical Formula 3]

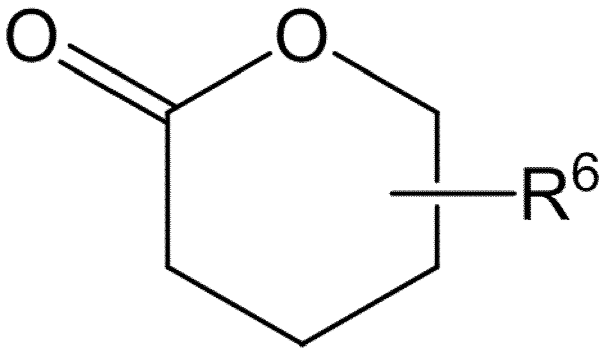

(3)

wherein $R^6$ represents a hydrogen atom or a monovalent organic group having 1 to 10 carbon atoms.

(4) A method for manufacturing a heat-resistant resin film, the method including the steps of applying the heat-resistant resin composition according to any one of the above (1) to (3) on a support substrate, drying the heat-resistant resin composition to form a coating film; and heat-treating the coating film.

(5) A method for manufacturing an interlayer insulation film or a surface protective film, the method including the steps of applying the heat-resistant resin composition according to any one of the above (1) to (3) on a support substrate, drying the heat-resistant resin composition to form a coating; and heat-treating the coating film.

(6) A method for manufacturing an electronic component or a semiconductor component including an interlayer insulation film or a surface protective film obtained by the method for manufacturing an interlayer insulation film or

a surface protective film according to the above (5).

(7) The method for manufacturing an electronic component or a semiconductor component according to the above (6), wherein 2 to 10 interlayer insulation films are used.

EFFECTS OF THE INVENTION

The present invention, which is defined in the appended claims, can provide a heat-resistant resin composition having excellent step embedding properties after being applied.

BRIEF DESCRIPTION OF THE DRAWINGS

Fig. 1 is an enlarged cross-sectional view of a semiconductor component having a surface protective film.

Fig. 2 is an enlarged cross-sectional view of a pad portion of a semiconductor component having an interlayer insulation film.

Fig. 3 is an enlarged cross-sectional view of a multilayer structure portion obtained by alternately laminating an insulating layer and a coil conductor layer in an electronic component.

Fig. 4 is an enlarged cross-sectional view of a heat-resistant resin film formed on a support substrate having step parts.

EMBODIMENTS OF THE INVENTION

A heat-resistant resin composition according to the present invention contains at least one resin selected from the group consisting of a polyimide, a polybenzoxazole, a polyimide precursor, and a polybenzoxazole precursor as a resin (A) ; an organic solvent having a boiling point of 210°C or higher and 260°C or lower at atmospheric pressure as an organic solvent (B) ; and an organic solvent having a boiling point of 100°C or higher and lower than 210°C at atmospheric pressure as an organic solvent (C), wherein a content of the organic solvent (B) is 5% by mass or more and 70% by mass or less with respect to the whole amount of the organic solvents; and a content of the organic solvent (C) is 30% by mass or more and 95% by mass or less with respect to the whole amount of the organic solvents. Each of the components will be described below.

The heat-resistant resin composition of the present invention can be formed into a polymer having an imide ring, an oxazole ring, or other cyclic structures under heating or a catalyst. Preferable examples thereof include a polyamic acid and a polyamic ester as a polyimide precursor, and a polyhydroxyamide as a polybenzoxazole precursor. The formation of the cyclic structure drastically improves heat resistance and solvent resistance.

A polyimide can be obtained by reacting a tetracarboxylic acid, its corresponding tetracarboxylic dianhydride, or tetracarboxylic acid diester dichloride with a diamine, its corresponding diisocyanate compound, or trimethylsilylated diamine, and has a tetracarboxylic acid residue and a diamine residue. For example, a polyimide can be obtained by the cyclodehydration of a polyamide acid, which is one of polyimide precursors obtained by reacting a tetracarboxylic dianhydride with a diamine, under a heating treatment. During the heating treatment, a solvent which azeotropically boils with water, such as m-xylene, may be added. Alternatively, a polyimide can also be obtained by adding, as a cyclization catalyst, a dehydration condensation agent such as a carboxylic anhydride or a dicyclohexyl carbodiimide, or a base such as trimethylamine, and subjecting the mixture to cyclodehydration under a chemical heating treatment. A polyimide can also be obtained by the cyclodehydration under a heating treatment at a low temperature of equal to or lower than 100°C with the addition of a weakly acidic carboxylic acid compound. A polyimide precursor will be described later.

A polybenzoxazole can be obtained by reacting a bisaminophenol compound with a dicarboxylic acid, its corresponding dicarboxylic acid chloride, or dicarboxylic acid active ester, and has a dicarboxylic acid residue and a bisaminophenol residue. For example, a polybenzoxazole can be obtained by the cyclodehydration of a polyhydroxyamide, which is one of polybenzoxazole precursors obtained by reacting a bisaminophenol compound with a dicarboxylic acid, under a heating treatment. Alternatively, a polybenzoxazole can also be obtained by adding a phosphoric anhydride, a base, or a carbodiimide compound, and subjecting the mixture to cyclodehydration under a chemical heating treatment. A polybenzoxazole precursor will be described later.

In the present invention, from the viewpoint of solubility in an aqueous alkali solution, the polyimide preferably has an acidic group or an acidic group derivative represented by $OR^7$, $SO_3R^7$, $CONR^7R^8$, $COOR^7$, or $SO_2NR^7R^8$, and more preferably has a hydroxyl group in a tetracarboxylic acid residue and/or a diamine residue. Here, $R^7$ and $R^8$ each independently represent a hydrogen atom or a monovalent organic group having 1 to 20 carbon atoms. The acidic group means a case where all of $R^7$ and $R^8$ are hydrogen atoms, and the acidic group derivative means a case where $R^7$ or $R^8$ contains a monovalent organic group having 1 to 20 carbon atoms. Examples of the organic group include an alkyl group, an alkoxyl group, and an ester group.

The polybenzoxazole preferably has an acidic group or an acidic group derivative represented by $OR^7$, $SO_3R^8$, $CONR^7R^8$, $COOR^7$, or $SO_2NR^7R^8$, and more preferably has a hydroxyl group in a dicarboxylic acid residue and/or a bisaminophenol residue. Here, $R^7$ and $R^8$ each independently represent a hydrogen atom or a monovalent organic group having 1 to 20 carbon atoms. The acidic group means a case where all of $R^7$ and $R^8$ are hydrogen atoms, and the acidic group derivative means a case where $R^7$ or $R^8$ contains a monovalent organic group having 1 to 20 carbon atoms. Examples of the organic group include an alkyl group, an alkoxyl group, and an ester group.

In the present invention, examples of preferred structures of the tetracarboxylic acid residue of the polyimide and the dicarboxylic acid residue of a polybenzoxazole (hereinafter, these residues are collectively referred to as an acid residue) include structures shown below and structures resulting from substituting 1 to 4 hydrogen atoms of these structures with an alkyl group having 1 to 20 carbon atoms, a fluoroalkyl group, an alkoxyl group, an ester group, a nitro group, a cyano group, a fluorine atom, or a chlorine atom.

[Chemical Formula 4]

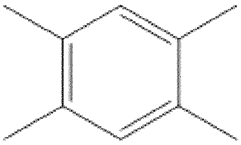
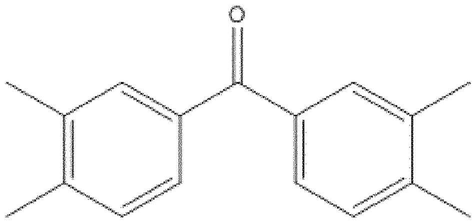
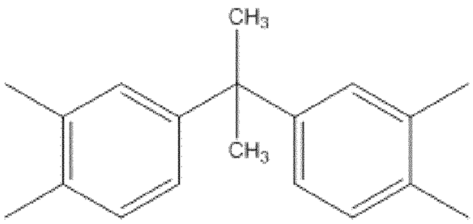
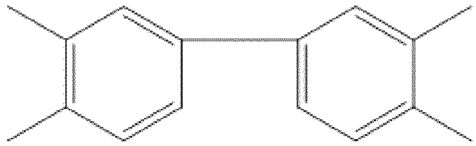
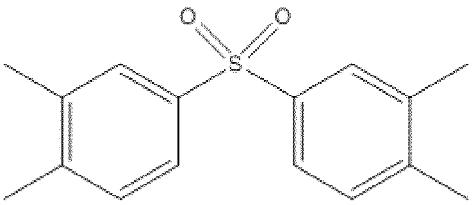
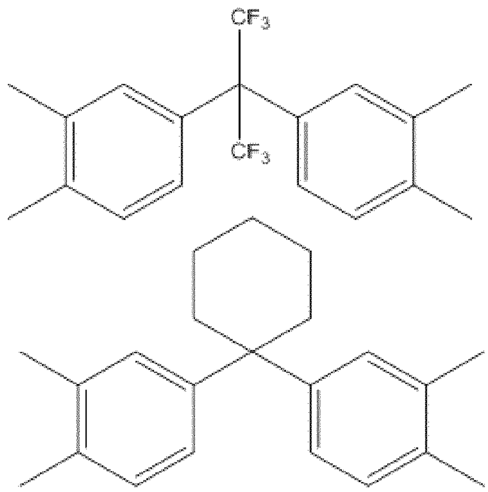
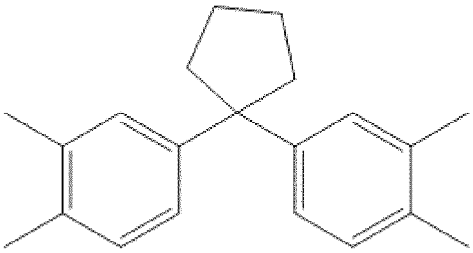
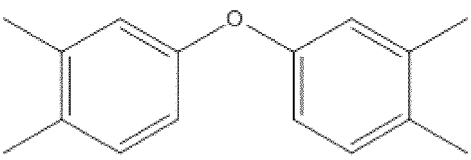
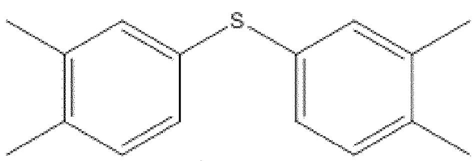
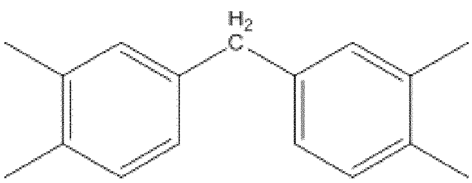
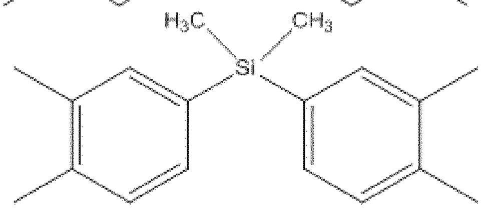
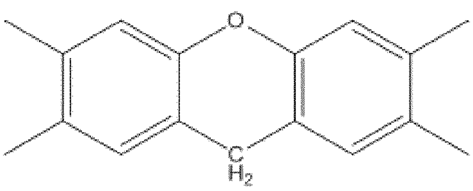
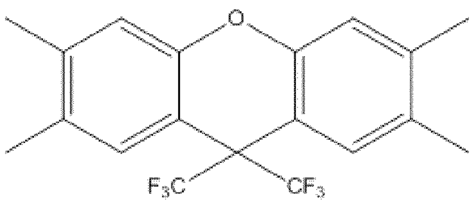

[Chemical Formula 5]

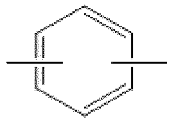
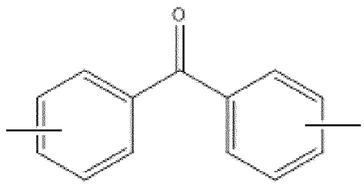

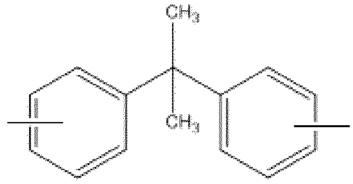
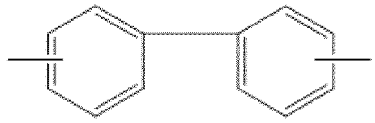

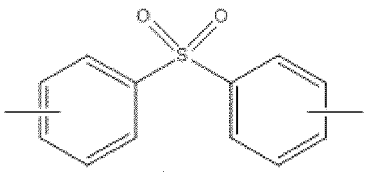
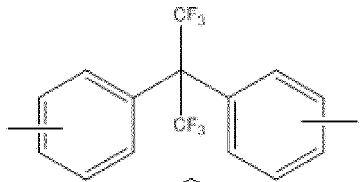

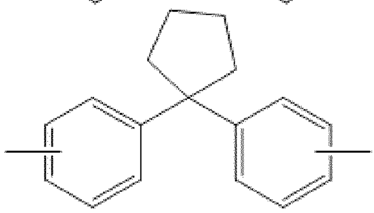
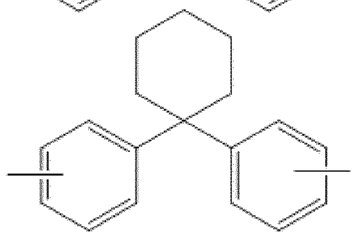

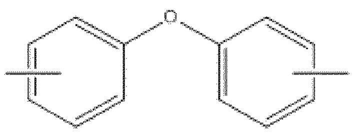
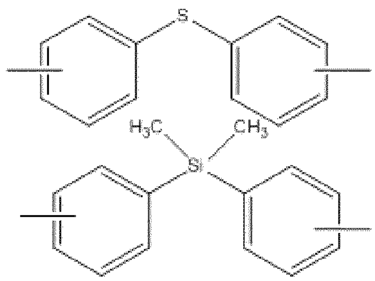

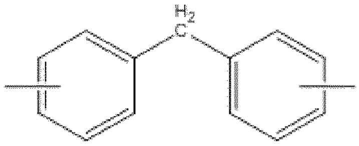

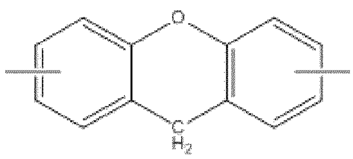
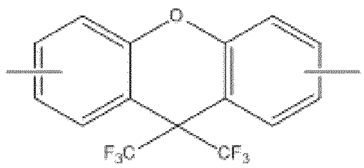

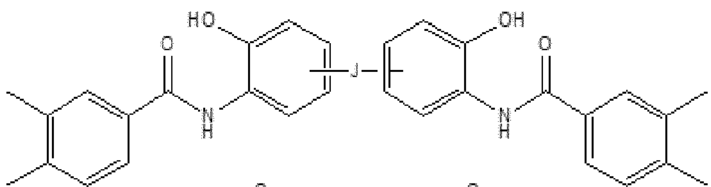

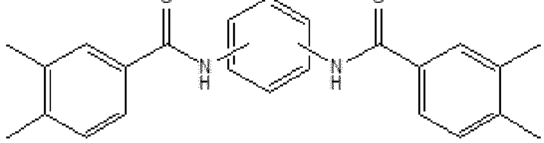

In the formula, J represents any of a direct bond, -COO-, -CONH-, $-CH_2-$, $-C_2H_4-$, -O-, $-C_3H_6-$, $-C_3F_6-$, $-SO_2-$, -S-, $-Si(CH_3)_2-$, $-OSi(CH_3)_2-O-$, $-C_6H_4-$, $-C_6H_4-O-C_6H_4-$, $-C_6H_4-C_3H_6-C_6H_4-$, and $-C_6H_4-C_3F_6-C_6H_4-$ .

In the present invention, examples of preferred structures of the diamine residue of the polyimide and the

bisaminophenol residue of the polybenzoxazole (hereinafter, these residues are collectively referred to as a diamine residue) include structures shown below and structures resulting from substituting 1 to 4 hydrogen atoms of these structures with an alkyl group having 1 to 20 carbon atoms, a fluoroalkyl group, an alkoxyl group, an ester group, a nitro group, a cyano group, a fluorine atom, or a chlorine atom.

[Chemical Formula 6]

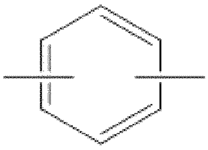
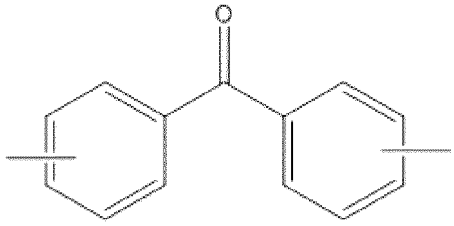
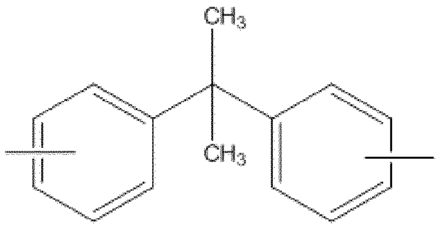
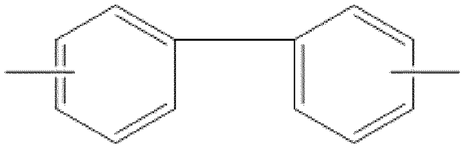
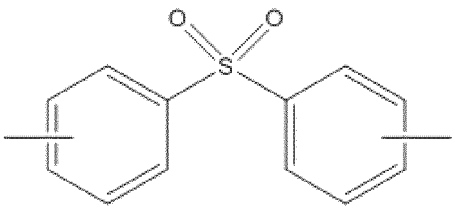
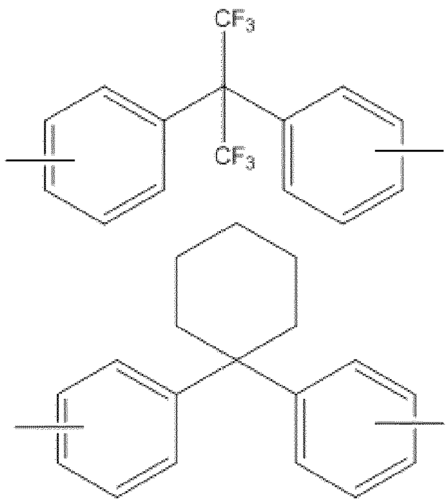
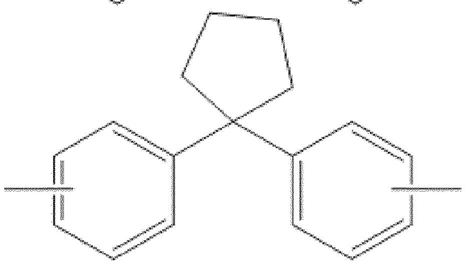
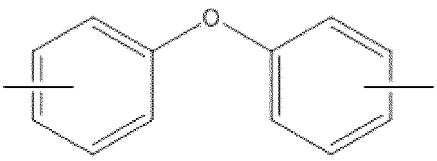
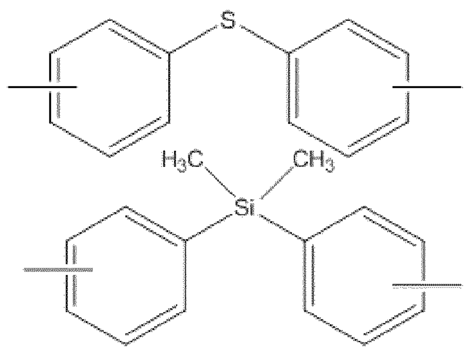
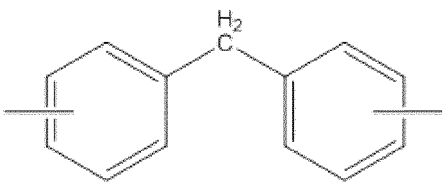
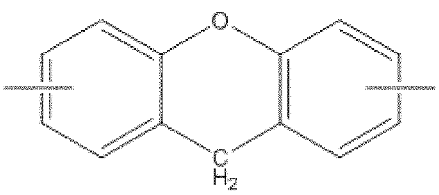
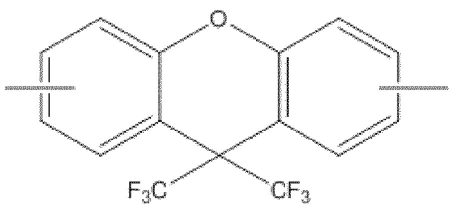

[Chemical Formula 7]

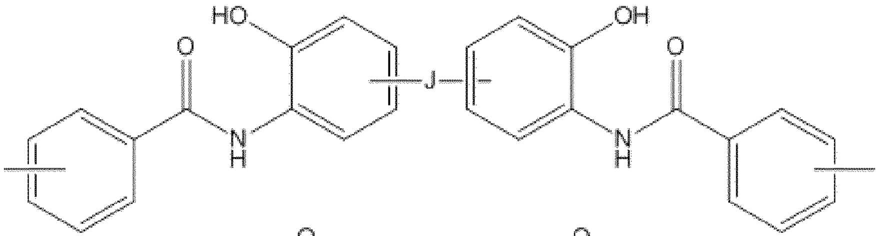

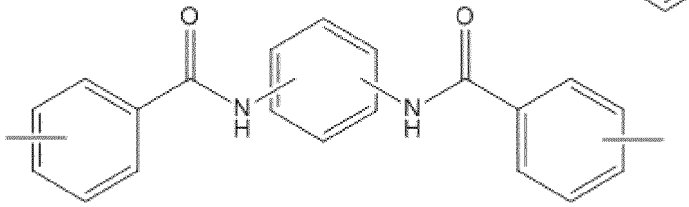

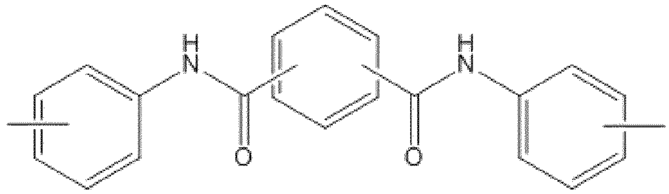

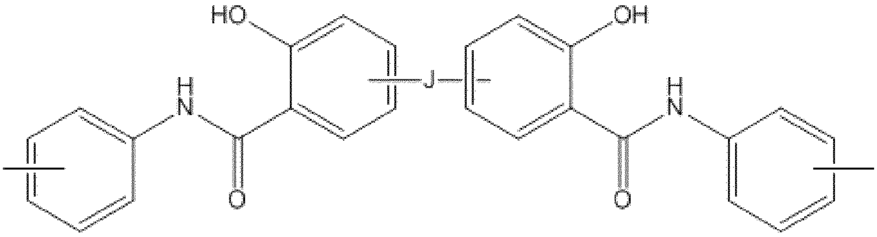

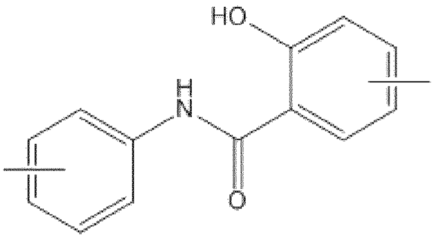

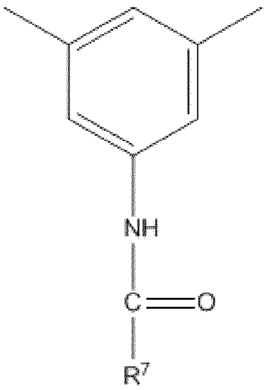

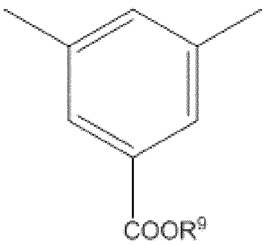

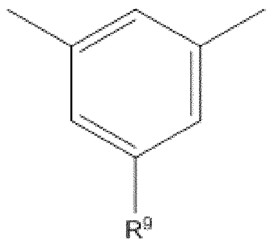

In the formulas, each of Js represents any of a direct bond, -COO-, -CONH-, $-CH_2-$, $-C_2H_4-$, -O-, $-C_3H_6-$, $-C_3F_6-$, $-SO_2-$, -S-, $-Si(CH_3)_2-$, $-O-Si(CH_3)_2-O-$, $-C_6H_4-$, $-C_6H_4-O-C_6H_4-$, $-C_6H_4-C_3H_6-C_6H_4-$, and $-C_6H_4-C_3F_6-C_6H_4-$. $R^9$s each represent a hydrogen atom or a monovalent organic group having 1 to 20 carbon atoms.

Among the resins (A) used in the present invention, the polyimide precursor and the polybenzoxazole precursor

are resins each having an amide bond in their main chain, and are subjected to cyclodehydration under a heating treatment or a chemical treatment to be formed into the aforementioned polyimide and polybenzoxazole. The number of repetitions of the structural units is preferably 10 to 100000. Examples of the polyimide precursor include a polyamide acid, a polyamic ester, a polyamide acid amide, and a polyisoimide, and a polyamide acid and a polyamic ester are preferred. Examples of the polybenzoxazole precursor include a polyhydroxyamide, a polyaminoamide, a polyamide, and a polyamideimide, and a polyhydroxyamide is preferred.

From the viewpoint of solubility in an aqueous alkali solution, the polyimide precursor and the polybenzoxazole precursor preferably have an acidic group or an acidic group derivative represented by $OR^{10}$, $SO_3R^{10}$, $CONR^{10}R^{11}$, $COOR^{10}$, or $SO_2NR^{10}R^{11}$, and more preferably have a hydroxyl group in an acid residue or an amine residue. Here, $R^{10}$ and $R^{11}$ each independently represent a hydrogen atom or a monovalent organic group having 1 to 20 carbon atoms. Here, the acidic group means a case where all of $R^{10}$ and $R^{11}$ are hydrogen atoms, and the acidic group derivative means a case where $R^{10}$ or $R^{11}$ contains a monovalent organic group having 1 to 20 carbon atoms. Examples of the organic group include an alkyl group, an alkoxyl group, and an ester group.

Regarding the acid component constituting the acid residue of the polyimide precursor and polybenzoxazole precursor, examples of a dicarboxylic acid include terephthalic acid, isophthalic acid, diphenyl ether dicarboxylic acid, bis(carboxyphenyl)hexafluoropropane, biphenyldicarboxylic acid, benzophenone dicarboxylic acid, and triphenyl dicarboxylic acid; example of a tricarboxylic acid include trimellitic acid, trimesic acid, diphenyl ether tricarboxylic acid, and biphenyl tricarboxylic acid; examples of a tetracarboxylic acid include aromatic tetracarboxylic acids such as pyromellitic acid, 3,3',4,4'-biphenyl tetracarboxylic acid, 2,3,3',4'-biphenyl tetracarboxylic acid, 2,2',3,3'-biphenyl tetracarboxylic acid, 3,3',4,4'-benzophenonetetracarboxylic acid, 2,2',3,3'-benzophenone tetracarboxylic acid, 2,2-bis(3,4-dicarboxyphenyl)hexafluoropropane, 2,2-bis(2,3-dicarboxyphenyl)hexafluoropropane, 1,1-bis(3,4-dicarboxyphenyl)ethane, 1,1-bis(2,3-dicarboxyphenyl)ethane, bis(3,4-dicarboxyphenyl)methane, bis(2,3-dicarboxyphenyl)methane, bis(3,4-dicarboxyphenyl)sulfone, bis(3,4-dicarboxyphenyl)ether, 1,2,5,6-naphthalenetetracarboxylic acid, 2,3,6,7-naphthalenetetracarboxylic acid, 2,3,5,6-pyridinetetracarboxylic acid, and 3,4,9,10-perylene tetracarboxylic acid, and aliphatic tetracarboxylic acids such as butanetetracarboxylic acid, cyclobutanetetracarboxylic acid, 1,2,3,4-cyclopentanetetracarboxylic acid, cyclohexanetetracarboxylic acid, bicyclo[2.2.1.]heptanetetracarboxylic acid, bicyclo[3.3.1.]tetracarboxylic acid, bicyclo[3.1.1.]hept-2-ene tetracarboxylic acid, bicyclo[2.2.2.]octane tetracarboxylic acid, and adamantane tetracarboxylic acid. It is preferable that a part of the hydrogen atoms of the dicarboxylic acid, tricarboxylic acid, or tetracarboxylic acid exemplified above is to substituted with an acidic group or an acidic group derivative represented by $OR^{10}$, $SO_3R^{10}$, $CONR^{10}R^{11}$, $COOR^{10}$, or $SO_2NR^{10}R^{11}$, and it is more preferable that 1 to 4 hydrogen atoms thereof is (are) substituted with a hydroxyl group, a sulfonic acid group, a sulfonic acid amide group, or a sulfonic acid ester group. Here, $R^{10}$ and $R^{11}$ each independently represent a hydrogen atom or a monovalent organic group having 1 to 20 carbon atoms.

These acids each can be used as it is or in the form of an acid anhydride or an active ester. Two or more thereof may be used.

The use of a silicon atom-containing tetracarboxylic acid such as dimethylsilane diphthalic acid or 1,3-bis(phthalic acid)tetramethyl disiloxane makes it possible to improve the adhesion to a support substrate, and the resistance to oxygen plasma used for cleaning and to UV ozone treatment. These silicon atom-containing tetracarboxylic acids are preferably used in an amount of 1 to 30 mol% of the whole acid component. The amount is preferably 1 mol% or more from the viewpoint of exhibiting the adhesion to a support substrate and the effect on a plasma treatment. The amount is preferably 30 mol% or less from the viewpoint of the solubility of the obtained resin in an aqueous alkali solution.

Examples of the diamine component constituting the diamine residue of the polyimide precursor and the polybenzoxazole precursor include hydroxyl group-containing diamines such as 2,2-bis(3-amino-4-hydroxyphenyl)hexafluoropropane, bis(3-amino-4-hydroxyphenyl)sulfone, bis(3-amino-4-hydroxyphenyl)propane, bis(3-amino-4-hydroxyphenyl)methylene, bis(3-amino-4-hydroxyphenyl)ether, bis(3-amino-4-hydroxy)biphenyl, and bis(3-amino-4-hydroxyphenyl)fluorine; carboxyl group-containing diamines such as 3,5-diaminobenzoic acid and 3-carboxy-4,4'-diaminodiphenyl ether; sulfonic acid-containing diamines such as 3-sulfonic acid-4,4-diaminodiphenyl ether; dithiohydroxyphenylenediamine, 3,4'-diaminodiphenyl ether, 4,4'-diaminodiphenyl ether, 3,4'-diaminodiphenylmethane, 4,4'-diaminodiphenylmethane, 3,4'-diaminodiphenyl sulfone, 4,4'-diaminodiphenyl sulfone, 3,4'-diaminodiphenylsulfide, 4,4'-diaminodiphenylsulfide, 1,4-bis(4-aminophenoxy)benzene, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis(4-aminophenoxy)biphenyl, bis{4-(4-aminophenoxy)phenyl}ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, 2,2'-di(trifluoromethyl)-4,4'-diaminobiphenyl, or compounds each resulting from substituting a part of hydrogen atoms of the aromatic ring of each of the foregoing with an alkyl group, or a halogen atom such as F, Cl, Br, or I, and aliphatic diamines such as cyclohexyldiamine and methylenebiscyclohexylamine. Furthermore, a part of hydrogen atoms of these diamines may be substituted with an alkyl group having 1 to 10 carbon atoms such as a methyl group or an ethyl group, a fluoroalkyl group having 1 to 10 carbon atoms such as a trifluoromethyl group, or a halogen atom such as F, Cl, Br, or I. The above-exemplified diamines

preferably have an acidic group or an acidic group derivative represented by $OR^{10}$, $SO_3R^{10}$, $CONR^{10}R^{11}$, $COOR^{10}$, or $SO_2NR^{10}R^{11}$, and more preferably have a hydroxyl group. Here, $R^{10}$ and $R^{11}$ each independently represent a hydrogen atom or a monovalent organic group having 1 to 20 carbon atoms.

These diamines can be used as they are or in the form of a corresponding diisocyanate compound or trimethylsilylated diamine. Two or more thereof may be used. In an application in which heat resistance is required, it is preferable to use an aromatic diamine in an amount of 50 mol% or more of the whole diamine.

The use of a silicon atom-containing diamine such as 1,3-bis(3-aminopropyl)tetramethyldisiloxane or 1,3-bis(4-anilino)tetramethyldisiloxane as a diamine component makes it possible to improve the adhesion to a support substrate, and the resistance to oxygen plasma used for cleaning and to UV ozone treatment. These silicon atom-containing diamines are preferably used in an amount of 1 to 30 mol% of the whole diamine component. The silicon atom-containing diamines used in an amount of 1 mol% or more make it possible to improve the adhesion property and the resistance to a plasma treatment, which is preferable. The amount is preferably 30 mol% or less from the viewpoint of the solubility of the obtained resin in an aqueous alkali solution.

It is preferable to cap the end of a polyimide, a polybenzoxazole, a polyimide precursor, or a polybenzoxazole precursor with a monoamine having a hydroxyl group, a carboxyl group, a sulfonic acid group, or a thiol group, an acid anhydride, a monocarboxylic acid, or an acid chloride. Two or more thereof may be used. The dissolution rate of a resin to an aqueous alkali solution can be easily adjusted to a preferable range by the possession of the aforementioned group at a resin end.

Preferable examples of the monoamine include 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 2-hydroxy-3-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-amino-4-tert-butylphenol, 2-aminothiophenol, 3-aminothiophenol, and 4-aminothiophenol.

Preferable examples of the acid anhydride, the monocarboxylic acid, and the acid chloride include acid anhydrides such as phthalic anhydride, maleic anhydride, nadic anhydride, cyclohexane dicarboxylic acid anhydride, and 3-hydroxyphthalic acid anhydride; monocarboxylic acids such as 3-carboxyphenol, 4-carboxyphenol, 3-carboxythiophenol, 4-carboxythiophenol, 1-hydroxy-7-carboxynaphthalene, 1-hydroxy-6-carboxynaphthalene, 1-hydroxy-5-carboxynaphthalene, 1-mercapto-7-carboxynaphthalene, 1-mercapto-6-carboxynaphthalene, 1-mercapto-5-carboxynaphthalene, 3-carboxybenzenesulfonic acid, and 4-carboxybenzenesulfonic acid, and monoacid chloride compounds resulting from conversion of their carboxyl groups to acid chlorides; monoacid chloride compounds resulting from conversion of only one carboxyl group of a dicarboxylic acid, such as terephthalic acid, phthalic acid, maleic acid, cyclohexane dicarboxylic acid, 1,5-dicarboxynaphthalene, 1,6-dicarboxynaphthalene, 1,7-dicarboxynaphthalene, and 2,6-dicarboxynaphthalene, into an acid chloride; and active ester compounds obtained through a reaction between a monoacid chloride compound and N-hydroxybenzotriazole or N-hydroxy-5-norbornene-2,3-dicarboxyimide.

The content of the end-capping agent, such as the aforementioned monoamine, acid anhydride, monocarboxylic acid, or acid chloride, is preferably in the range of 0.1 to 60 mol% of the number of moles of the charged acid component monomer or diamine component monomer, and more preferably 5 to 50 mol%. By adjusting the content to such a range, it is possible to obtain a heat-resistant resin composition that is moderate in viscosity of its solution when applying the heat-resistant resin composition and that has excellent film physical properties.

The end-capping agent introduced into the resin can be easily detected by the following method. For example, the end-capping agent can be detected easily by dissolving a resin into which the end-capping agent is introduced in an acidic solution to decompose the resin into a diamine component and an acid component which are constitutional units of the resin, and then measuring them by gas chromatography (GC) or NMR. Aside from this, a resin into which the end-capping agent is introduced can be detected directly through the measurements of a pyrolysis gas chromatograph (PGC), an infrared spectrum, and a $^{13}C$-NMR spectrum.

The resin may also have a polymerizable functional group at its end. Examples of the polymerizable functional group include an ethylenically unsaturated linking group, an acetylene group, a methylol group, and an alkoxymethyl group.

In the present invention, the resin (A) is preferably a polyimide precursor or a polybenzoxazole precursor, and more preferably a polyimide precursor. The polyimide precursor advances an imidation reaction in which an amide acid moiety is cyclized by firing at about 200°C. The polybenzoxazole precursor advances an oxazolation reaction in which a hydroxyamide moiety is cyclized by firing at about 300°C. As a result, the polybenzoxazole precursor has a property to volumetrically shrink.

The heat-resistant resin composition of the present invention may contain other alkali-soluble resins in addition to the resin (A) . An alkali-soluble resin refers to any resin having an acidic group to become soluble in alkali, and specific

examples thereof include a radically polymerizable resin having acrylic acid, a phenol-novolac resin, a polyhydroxystyrene, and a polysiloxane. The alkali solubility may be adjusted by protecting the acidic groups of these resins. Such a resin is dissolved in an aqueous solution of an alkali, such as choline, triethylamine, dimethylaminopyridine, monoethanolamine, diethylaminoethanol, sodium hydroxide, potassium hydroxide, and sodium carbonate as well as tetramethylammonium hydroxide. Two or more of these resins may be contained, but their proportion to the whole resin (A) is preferably 70% by mass or less from the viewpoint that a heat-resistant resin film having excellent film physical properties after firing can be obtained.

The heat-resistant resin composition of the present invention contains, as the organic solvent (B), an organic solvent having a boiling point of 210°C or higher and 260°C or lower at atmospheric pressure. The heat-resistant resin composition contains an organic solvent having a boiling point of 210°C or higher and 260°C or lower at atmospheric pressure, so that it is possible to alleviate a decrease in flowability due to the drying of the heat-resistant resin composition during applying the heat-resistant resin composition and the subsequent drying step to improve the step part embedding properties of the support substrate. When the boiling point of the organic solvent (B) at atmospheric pressure is 210°C or higher, a decrease in flowability due to the drying of the coating film during applying the heat-resistant resin composition and the drying step can be alleviated, which is preferable. When the boiling point is 260°C or lower, the remaining of the organic solvent in the heat resistant resin film after firing is suppressed, which is preferable. The boiling point is more preferably 250°C or lower.

In the heat-resistant resin composition of the present invention, the organic solvent (B) preferably contains at least one organic solvent selected from the group consisting of an organic solvent represented by the following general formula (1), an organic solvent represented by the following general formula (2), and an organic solvent represented by the following formula (3). The organic solvent having such a structure has a property of dissolving and mixing a substance having a wide range of polarity, which makes it possible to sufficiently dissolve the resin (A).

[Chemical Formula 8]

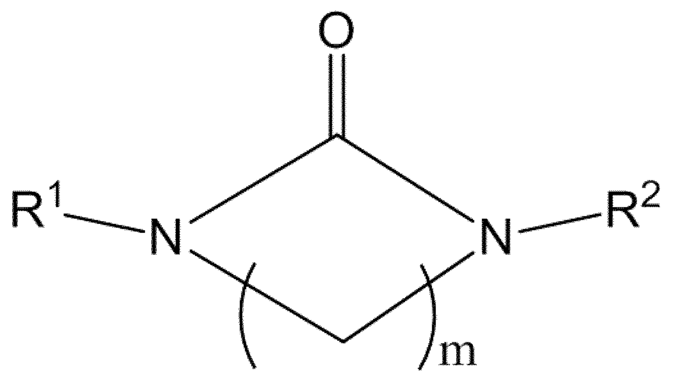

(1)

In the general formula (1), $R^1$ and $R^2$ may be the same or different from each other, and each represent a monovalent organic group having 1 to 10 carbon atoms. m represents an integer of 1 to 5.

[Chemical Formula 9]

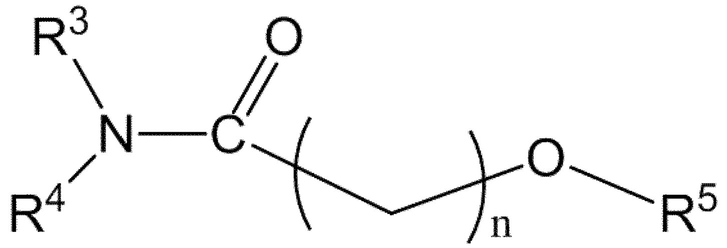

(2)

In the general formula (2), $R^3$, $R^4$ and $R^5$ may be the same or different from one another, and each represent a monovalent organic group having 1 to 10 carbon atoms. n represents an integer of 1 to 10.

[Chemical Formula 10]

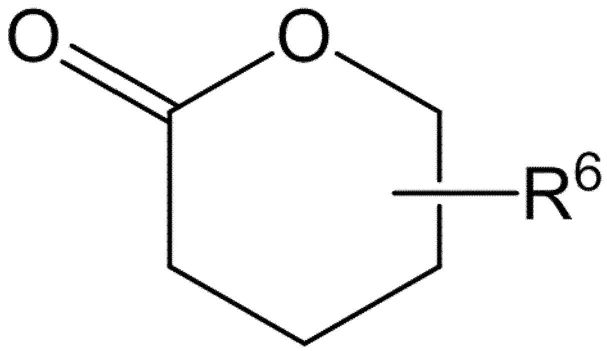

(3)

In the general formula (3), $R^6$ represents a hydrogen atom or a monovalent organic group having 1 to 10 carbon atoms.

Specific examples of the organic solvent (B) include 1,3-dimethyl-2-imidazolidinone (boiling point: 220°C), N,N-dimethylpropyleneurea (boiling point: 246°C), 3-methoxy-N,N-dimethylpropionamide (boiling point: 216°C), and delta valerolactone (boiling point: 230°C) .

In the present invention, the content of the organic solvent (B) is 5% by mass or more and 70% by mass or less with respect to the whole amount of the organic solvents. The content of the organic solvent (B) is preferably 5% by mass or more, more preferably 15% by mass or more, and still more preferably 30% by mass or more from the viewpoint that a sufficient step embedding effect can be obtained under the presence of a high boiling point solvent. On the other hand, the content of the organic solvent (B) is preferably 70% by mass or less from the viewpoint that the boiling point of the solvent contained in the heat-resistant resin composition can be maintained to such an extent that a time is not required for the drying step, and more preferably 60% by mass or less and still more preferably 50% by mass or less from the viewpoint that the remaining of the organic solvent in the film after firing can be suppressed.

The heat-resistant resin composition of the present invention contains, as the organic solvent (C), an organic solvent having a boiling point of 100°C or higher and lower than 210°C at atmospheric pressure. The heat-resistant resin composition contains the organic solvent (C) in addition to the organic solvent (B), so that it is possible to remove the organic solvent from the coating film in a short time in the drying step. On the other hand, when the boiling point at atmospheric pressure is 100°C or higher, the dissolution of the resin (A) proceeds, which makes it possible to avoid a situation where a solid content is deposited.

In the present invention, the content of the organic solvent (C) is 30% by mass or more and 95% by mass or less with respect to the whole amount of the organic solvents, and the total of the organic solvent (B) and the organic solvent (C) is 100% by mass or less with respect to the whole amount of the organic solvents. The content of the organic solvent (C) is preferably 30% by mass or more, more preferably 40% by mass or more, and still more preferably 50% by mass or more from the viewpoint that the boiling point of the solvent contained in the heat-resistant resin composition can be maintained to such an extent that a time is not required for the drying step. On the other hand, the content of the organic solvent (C) is preferably 95% by mass or less, more preferably 85% by mass or less, and still more preferably 70% by mass from the viewpoint that a sufficient step embedding effect can be obtained by the combination with the organic solvent (B).

In the heat-resistant resin composition of the present invention, the organic solvent (C) contains an organic solvent having a boiling point of 140°C or higher and lower than 210°C at atmospheric pressure as an organic solvent (C-1), and an organic solvent having a boiling point of 100°C or higher and lower than 140°C at atmospheric pressure as an organic solvent (C-2) .

When the boiling point at atmospheric pressure of the organic solvent (C-1) is lower than 210°C, the organic solvent can be removed from the coating film in a shorter time than the organic solvent (B) alone in the drying step, which is preferable. The boiling point is more preferably 200°C or lower. When the boiling point is 140°C or higher, a decrease in flowability due to the drying of the heat-resistant resin composition can be suppressed because the heat-resistant resin composition is dried in the range of 70 to 130°C using an oven, a hot plate, or infrared rays in the drying step as will be described later, which is preferable. The boiling point is more preferably 150°C or higher.

When the boiling point at atmospheric pressure of the organic solvent (C-2) is lower than 140°C, the organic solvent can be removed from the coating film in a shorter time than the two-kind mixed solvent of the organic solvent (B) and the organic solvent (C-1), which is preferable. The boiling point is more preferably 130°C or less. When the boiling point is 100°C or higher, the deposition of the solid content of the resin (A) due to solvent volatilization can be suppressed, which is preferable. The boiling point is more preferably 110°C or higher.

In the present invention, the ratio of the content of the organic solvent (C-1) to the content of the organic solvent (C-2) is 1 : 9 to 9 : 1 by mass ratio. When the ratio of the content of the organic solvent (C-1) to the content of the organic

solvent (C-2) is 1 : 9 to 9 : 1, a decrease in flowability due to the drying of the heat-resistant resin composition is suppressed, and the organic solvent is likely to be removed from the coating film in a short time, which is preferable. The ratio of the content of the organic solvent (C-1) to the content of the organic solvent (C-2) is preferably 2 : 8 to 8 : 2, and more preferably 3 : 7 to 7 : 3.

The combination of the organic solvent (B), the organic solvent (C-1), and the organic solvent (C-2) as the organic solvents remarkably exhibits an effect of improving step embedding properties involving the retention of the flowability of the heat-resistant resin composition during applying the heat-resistant resin composition and the subsequent drying step.

The reason why such an effect can be obtained is presumed as follows. First, in the initial stage of the applying and drying step of the heat-resistant resin composition, the organic solvent (C-2) having a low boiling point is mainly volatilized, and the drying of the surface of the coating film advances. At the same time, the organic solvent (B) and the organic solvent (C-1) each having a high boiling point alleviate the drying of the inside of the coating film to maintain its flowability, so that step parts of a support substrate are covered with the heat-resistant resin composition. In the middle stage of the drying step, the organic solvent (B) and the organic solvent (C-1) are also volatilized in addition to the organic solvent (C-2) to further advance the drying. However, the organic solvent (B) having a high boiling point remains in a large amount to maintain its flowability, so that the film surface of the covered step parts of the support substrate is flattened. In the last stage of the drying step, the organic solvent (B) is also volatilized to further advance the drying, which provides a cured flat coating film. Thus, the combination of the three kinds of the organic solvent (B), the organic solvent (C-1), and the organic solvent (C-2) provides a coating film having high flatness in which the step parts of the support substrate is covered while the organic solvent is removed in a short time.

The organic solvent (C-1) preferably dissolves the resin (A) . Specific examples thereof include ethyl lactate (boiling point: 154°C), butyl lactate (boiling point: 186°C), dipropylene glycol dimethyl ether (boiling point: 171°C), diethylene glycol dimethyl ether (boiling point: 162°C), diethylene glycol ethyl methyl ether (boiling point: 176°C), diethylene glycol diethyl ether (boiling point: 189°C), 3-methoxybutyl acetate (boiling point: 171°C), ethylene glycol monoethyl ether acetate (boiling point: 160°C), gamma butyrolactone (boiling point: 203°C), N-methyl-2-pyrrolidone (boiling point: 204°C), diacetone alcohol (boiling point: 166°C ), N-cyclohexyl-2-pyrrolidone (boiling point: 154°C ), N,N-dimethylformamide (boiling point: 153°C), N,N-dimethylacetamide (boiling point: 165°C), dimethylsulfoxide (boiling point 189°C), propylene glycol monomethyl ether acetate (boiling point: 146°C), and N,N-dimethylisobutyramide (boiling point: 175°C). From the viewpoint of the storage stability and viscosity stability of the heat-resistant resin composition, ethyl lactate, diethylene glycol ethyl methyl ether, or N,N-dimethylisobutyramide is more preferable.

The organic solvent (C-2) preferably dissolves the resin (A). Specific examples thereof include alkylene glycol monoalkyl ethers such as ethylene glycol monomethyl ether (boiling point: 124°C) and propylene glycol monomethyl ether (boiling point: 120°C); alkyl acetates such as propyl acetate (boiling point: 102°C), butyl acetate (boiling point: 125°C), and isobutyl acetate (boiling point: 118°C); ketones such as methyl isobutyl ketone (boiling point: 116°C) and methyl propyl ketone (boiling point: 102°C); and alcohols such as butyl alcohol (boiling point: 117°C) and isobutyl alcohol (boiling point: 108°C) . From the viewpoint of the storage stability and viscosity stability of the heat-resistant resin composition, propylene glycol monomethyl ether is more preferable.

The boiling points at atmospheric pressure of the organic solvents is described in documents such as "CRC Handbook of Chemistry and Physics" and "Aldrich Handbook of Fine Chemical and Laboratory Equipment". The boiling points of organic solvents which are not described in known documents can be measured with a commercially available boiling point measuring apparatus, for example, FP 81HT/FP 81C (manufactured by Mettler-Toledo).

The content of the whole organic solvents in the present invention is preferably 50 parts by mass to 2000 parts by mass with respect to 100 parts by mass of the resin (A). When the content is 50 parts by mass or more, the polymer is dissolved in the organic solvent without being deposited, which is preferable. The content is more preferably 100 parts by mass or more. When the content is 2, 000 parts by mass or less, the viscosity of the resin (A) can be controlled so as to be suitable for application, which is preferable. The content is more preferably 1500 parts by mass or less.

In the present invention, the solubility parameter (SP value) of each of the organic solvent (B), the organic solvent (C-1), and the organic solvent (C-2) is preferably 7.0 or more and 13.0 or less. When the SP value of each of the organic solvent (B), the organic solvent (C-1), and the organic solvent (C-2) is 7.0 or more, the deposition of the solid content of the resin (A) is likely to be suppressed. The SP value is more preferably 7.5 or more. When the solubility parameter of each of the organic solvent (B), the organic solvent (C-1), and the organic solvent (C-2) is 13.0 or less, the solubility with the resin (A) is likely to be improved. The SP value is more preferably 12.5 or less. As the solubility parameters (SP values) in the present invention, document values described in "Basic Science of Coating" (page 65, Yuji Harasaki, Maki Shoten) were used. As those having no SP values, values calculated from the evaporation energies and molar volumes of atoms and atomic groups by Fedors in "Basic Science of Coating" (page 55, Yuji Harasaki, Maki Shoten) were used.

Specific examples of the organic solvent (B) include 1,3-dimethyl-2-imidazolidinone (SP value: 11.4, calculated value), N,N-dimethylpropyleneurea (SP value: 11.1, calculated value), 3-methoxy-N,N-dimethylpropionamide (SP value:

10.3, calculated value), and delta valerolactone (SP value: 9.7, calculated value). Specific examples of the organic solvent (C-1) include ethyl lactate (SP value: 10.6, document value), butyl lactate (SP value: 9.7, document value), dipropylene glycol dimethyl ether (SP value: 7.9, calculated value), diethylene glycol dimethyl ether (SP value: 8.1, calculated value), diethylene glycol ethyl methyl ether (SP value: 8.1, calculated value), diethylene glycol diethyl ether (SP value: 8.2, calculated value), 3-methoxybutyl acetate (SP value: 8.7, calculated value), ethylene glycol monoethyl ether acetate (SP value: 9.0, calculated value), gamma butyrolactone (SP value: 12.8, document value), N-methyl-2-pyrrolidone (SP value: 11.2, document value), diacetone alcohol (SP value: 10.2, document value), N-cyclohexyl-2-pyrrolidone (SP value 10.8, document value), N,N-dimethylformamide (SP value: 12.1, document value), N,N-dimethylacetamide (SP value 11.1, document value), dimethylsulfoxide (SP Value: 12.9, document value), propylene glycol monomethyl ether acetate (SP value 8.7, calculated value), and N,N-dimethylisobutyramide (SP value: 9.9, calculated value). Specific examples of the organic solvent (C-2) include ethylene glycol monomethyl ether (SP value: 10.8, calculated value), propylene glycol monomethyl ether (SP value: 10.2, calculated value), propyl acetate (SP value: 8.7, calculated value), butyl acetate (SP value: 8.5, document value), isobutyl acetate (SP value: 8.4, document value), methyl isobutyl ketone (SP value: 8.6, document value), methyl propyl ketone (SP value: 8.9, calculated value), butyl alcohol (SP value: 11.3, document value), and isobutyl alcohol (SP value: 11.1, document value).

The heat-resistant resin composition of the present invention may contain a photosensitizer (D). Examples of the photosensitizer (D) include a photoacid generator (D-1), and a combination of a photopolymerization initiator (D-2) and a compound (D-3) having two or more ethylenically unsaturated bonds. When the heat-resistant resin composition of the present invention contains the photoacid generator (D-1), an acid is generated in a part exposed to light, so that the solubility of the part exposed to light in an aqueous alkali solution is increased and a positive type relief pattern in which the part exposed to light dissolves can be obtained. The heat-resistant resin composition of the present invention contains the photoacid generator (D-1) and an epoxy compound or a thermal crosslinking agent described later, which makes it possible to obtain a negative type relief pattern in which an acid generated in a part exposed to light promotes the crosslinking reactions of the epoxy compound or the thermal crosslinking agent, so that the part exposed to light becomes insoluble. The resin composition contains the photopolymerization initiator (D-2) and the compound (D-3) having two or more ethylenically unsaturated bonds, which makes it possible to obtain a negative type relief pattern in which an active radical generated in a part exposed to light advances the radical polymerization of the ethylenically unsaturated bonds, so that the part exposed to light becomes insoluble.

Examples of the photoacid generator (D-1) include a quinone diazide compound, a sulfonium salt, a phosphonium salt, a diazonium salt, and an iodonium salt.

Examples of the quinone diazide compound include a compound in which the sulfonic acid of quinone diazide is bonded to a polyhydroxy compound via an ester, a compound in which the sulfonic acid of quinone diazide is sulfonamide-bonded to a polyamino compound, and a compound in which the sulfonic acid of quinone diazide is ester-bonded and/or sulfonamide-bonded to a polyhydroxypolyamino compound. It is preferable that 50 mol% or more of the whole functional groups in the polyhydroxy compound or the polyamino compound are substituted with quinone diazide. Two or more of the photoacid generators (D-1) are preferably added, which makes it possible to obtain a heat-resistant resin composition having high photosensitivity.

In the present invention, a quinone diazide compound that has any of a 5-naphthoquinone diazide sulfonyl group and a 4-naphthoquinone diazide sulfonyl group is preferably used. A 4-naphthoquinone diazide sulfonyl ester compound is suitable for i-line exposure because it has an absorption in the i-line region of a mercury lamp. A 5-naphthoquinone diazide sulfonyl ester compound is suitable for g-line exposure because it has an absorption extending to the g-line region of a mercury lamp. In the present invention, it is preferable to select a 4-naphthoquinone diazide sulfonyl ester compound and a 5-naphthoquinone diazide sulfonyl ester compound depending upon the wavelength of light to be applied. A naphthoquinone diazide sulfonyl ester compound having a 4-naphthoquinone diazide sulfonyl group and a 5-naphthoquinone diazide sulfonyl group in the same molecule may be contained, and a 4-naphthoquinone diazide sulfonyl ester compound and a 5-naphthoquinone diazide sulfonyl ester compound may be contained.

Among the photoacid generators (D-1), a sulfonium salt, a phosphonium salt, and a diazonium salt are preferable because they moderately stabilize the acid component generated by exposure to light. Among them, a sulfonium salt is preferable. Furthermore, or a sensitizer may be contained if necessary.

Examples of the photopolymerization initiator (D-2) include diethoxyacetophenone, 2-hydroxy-2-methyl-1-phenylpropan-1-one, benzyl dimethyl ketal, 1-(4-isopropylphenyl)-2-hydroxy-2-methylpropan-1-one, 4-(2-hydroxyethoxy)phenyl-(2-hydroxy-2-propyl)ketone, 1-hydroxycyclohexyl-phenyl ketone, 1-phenyl-1,2-propanedione-2-(o-ethoxycarbonyl)oxime, 2-methyl-[4-(methylthio)phenyl]-2-morpholinopropan-1-one, 2-benzyl-2-dimethylamino-1-(4-morpholinophenyl)-butanone-1, benzoin, benzoin methyl ether, benzoin ethyl ether, benzoin isopropyl ether, benzoin isobutyl ether, benzophenone, methyl o-benzoylbenzoate, 4-phenylbenzophenone, 4,4-dichlorobenzophenone, hydroxybenzophenone, 4-benzoyl-4'-methyl-diphenyl sulfide, alkylated benzophenone, 3,3',4,4'-tetra(tert-butylperoxycarbonyl)benzophenone, 4-benzoyl-N,N-dimethyl-N-[2-(1-oxo-2-propenyloxy)ethyl]benzene methanaminium bromide, (4-benzoylbenzyl)trimethylammonium chloride, 2-hydroxy-3-(4-benzoylphenoxy)-N,N,N-trimethyl-1-propene aminium

chloride monohydrate, 2-isopropylthioxanthone, 2,4-dimethylthioxanthone, 2,4-diethylthioxanthone, 2,4-dichlorothioxanthone, 2-hydroxy-3-(3,4-dimethyl-9-oxo-9H-thioxanthen-2-yloxy)-N,N,N-trimethyl-1-propanaminium chloride, 2,4,6-trimethylbenzoylphenylphosphine oxide, 1,2-octanedione-1-[4-(phenylthio)-2-(O-benzoyloxime)], ethanone, 1-[9-ethyl-6-(2-methylbenzoyl)-9H-carbazol-3-yl]-, 1-(O-acetyloxime), 2,2'-bis(o-chlorophenyl)-4,5,4',5'-tetraphenyl-1,2-biimidazole, 10-butyl-2-chloroacridone, 2-ethylanthraquinone, benzil, 9,10-phenanthrenequinone, camphorquinone, methylphenylglyoxy ester, η5-cyclopentadienyl-η6-cumenyl-iron(1+)-hexafluorophosphate(1-), diphenylsulfide derivatives, bis(η5-2,4-cyclopentadien-1-yl)-bis(2,6-difluoro-3-(1H-pyrrol-1-yl)-phenyl)titanium, 4,4-bis(dimethylamino)benzophenone, 4,4-bis(diethylamino)benzophenone, thioxanthone, 2-methylthioxanthone, 2-chlorothioxanthone, 4-benzoyl-4-methylphenyl ketone, dibenzyl ketone, fluorenone, 2,3-diethoxyacetophenone, 2,2-dimethoxy-2-phenyl-2-phenylacetophenone, 2-hydroxy-2-methylpropiophenone, p-t-butyldichloroacetophenone, benzilmethoxyethyl acetal, anthraquinone, 2-tert-butyl anthraquinone, 2-aminoanthraquinone, β-chloroanthraquinone, anthrone, benzanthrone, dibenzsuberone, methyleneanthrone, 4-azidobenzalacetophenone, 2,6-bis(p-azidobenzylidene)cyclohexane, 2,6-bis(p-azidobenzylidene)-4-methylcyclohexanone, 2-phenyl-1,2-butadione-2-(o-methoxycarbonyl)oxime, 1,3-diphenylpropanetrione-2-(o-ethoxycarbonyl)oxime, naphthalenesulfonyl chloride, quinolinesulfonyl chloride, N-phenylthioacridone, 4,4-azobisisobutyronitrile, benzthiazole disulfide, triphenylphosphine, tetrabromocarbon, tribromophenylsulfone, benzoyl peroxide, and combinations of photoreductive dyes such as eosin and methylene blue, and reducing agents such as ascorbic acid and triethanolamine . Two or more thereof may be contained.

Examples of the compound (D-3) having two or more ethylenically unsaturated bonds include acrylic monomers such as ethylene glycol dimethacrylate, ethylene glycol diacrylate, diethylene glycol dimethacrylate, trimethylolpropane triacrylate, ethoxylated bisphenol A dimethacrylate, glycerol dimethacrylate, tripropylene glycol dimethacrylate, butanediol dimethacrylate, glycerol triacrylate, pentaerythritol triacrylate, pentaerythritol tetraacrylate, dipentaerythritol hexaacrylate, ethoxylated pentaerythritol tetraacrylate, and ethoxylated isocyanuric acid triacrylate. Two or more thereof may be contained.

The content of the photosensitizer (D) is preferably 0.01 to 50 parts by mass with respect to 100 parts by mass of the resin (A).

The content of the photoacid generator (D-1) is preferably 0.01 to 50 parts by mass with respect to 100 parts by mass of the resin (A) from the viewpoint of high sensitivity. Among them, the amount of the quinone diazide compound is preferably 3 to 40 parts by mass. The total amount of the sulfonium salt, phosphonium salt, and diazonium salt is preferably 0.5 to 20 parts by mass. In the above range, the added amount is not excessive, and the residue of the developed pattern is not caused. Therefore, a sufficient acid is generated with exposure to light and this provides an improvement in sensitivity, which is preferable.

The content of the photopolymerization initiator (D-2) is preferably 0.1 to 20 parts by mass with respect to 100 parts by mass of the resin (A) . When the content is 0.1 parts by mass or more, sufficient radicals are generated by exposure to light, which provides an improvement in sensitivity. When the content is 20 parts by mass or less, a part unexposed to light is not cured by the generation of excessive radicals, which provides an improvement in alkali developability.

The content of the compound (D-3) having two or more ethylenically unsaturated bonds is preferably 5 to 50 parts by mass with respect to 100 parts by mass of the resin (A) . When the content is 5 parts by mass or more, the active radicals sufficiently advance the radical polymerization of the ethylenically unsaturated bonds, which preferably provides an improvement in sensitivity. When the content is 50 parts by mass or less, a part unexposed to light is not cured by the advance of excessive radical polymerization, which preferably provides an improvement in alkali developability.

For adjusting solubility, a compound having one ethylenically unsaturated bond may be contained in an amount of 1 to 50 parts by mass with respect to 100 parts by mass of the resin (A). Examples of such a compound include acrylic acid, methacrylic acid, methyl acrylate, methyl methacrylate, butyl acrylate, hydroxyethyl acrylate, hydroxyethyl methacrylate, dimethyl acrylamide, dimethylaminoethyl methacrylate, acryloyl morpholine, 1-hydroxyethyl α-chloroacrylate, 2-hydroxyethyl methacrylate, 2-hydroxyethyl acrylate, 2-hydroxyethyl α-chloroacrylate, 1-hydroxypropyl methacrylate, 1-hydroxypropyl acrylate, 1-hydroxypropyl α-chloroacrylate, 2-hydroxypropyl methacrylate, 2-hydroxypropyl acrylate, 2-hydroxypropyl α-chloroacrylate, 3-hydroxypropyl methacrylate, 3-hydroxypropyl acrylate, 3-hydroxypropyl α-chloroacrylate, 1-hydroxy-1-methylethyl methacrylate, 1-hydroxy-1-methylethyl acrylate, 1-hydroxy-1-methylethyl α-chloroacrylate, 2-hydroxy-1-methylethyl methacrylate, 2-hydroxy-1-methylethyl acrylate, 2-hydroxy-1-methylethyl α-chloroacrylate, 1-hydroxybutyl methacrylate, 1-hydroxybutyl acrylate, 1-hydroxybutyl α-chloroacrylate, 2-hydroxybutyl methacrylate, 2-hydroxybutyl acrylate, 2-hydroxybutyl α-chloroacrylate, 3-hydroxybutyl methacrylate, 3-hydroxybutyl acrylate, 3-hydroxybutyl α-chloroacrylate, 4-hydroxybutyl methacrylate, 4-hydroxybutyl acrylate, 4-hydroxybutyl α-chloroacrylate, 1-hydroxy-1-methylpropyl methacrylate, 1-hydroxy-1-methylpropyl acrylate, 1-hydroxy-1-methylpropyl α-chloroacrylate, 2-hydroxy-1-methylpropyl methacrylate, 2-hydroxy-1-methylpropyl acrylate, 2-hydroxy-1-methylpropyl α-chloroacrylate, 1-hydroxy-2-methylpropyl methacrylate, 1-hydroxy-2-methylpropyl acrylate, 1-hydroxy-2-methylpropyl α-chloroacrylate, 2-hydroxy-2-methylpropyl methacrylate, 2-hydroxy-2-methylpropyl acrylate, 2-hydroxy-2-methylpropyl α-chloroacrylate,

2-hydroxy-1,1-dimethylethyl methacrylate, 2-hydroxy-1,1-dimethylethyl acrylate, 2-hydroxy-1,1-dimethylethyl α-chloroacrylate, 1,2-dihydroxypropyl methacrylate, 1,2-dihydroxypropyl acrylate, 1,2-dihydroxypropyl α-chloroacrylate, 2,3-dihydroxypropyl methacrylate, 2,3-dihydroxypropyl acrylate, 2,3-dihydroxypropyl α-chloroacrylate, 2,3-dihydroxybutyl methacrylate, 2,3-dihydroxybutyl acrylate, 2,3-dihydroxybutyl α-chloro acrylate, p-hydroxystyrene, p-isopropenylphenol, phenethyl methacrylate, phenethyl acrylate, phenethyl α-chloroacrylate, N-methylolacrylamide, N-methylolmethacrylamide, α-chloroacrylic acid, crotonic acid, 4-pentenoic acid, 5-hexenoic acid, 6-heptenoic acid, 7-octenoic acid, 8-nonanoic acid, 9-decanoic acid, 10-undecylenic acid, brassidic acid, ricinoleic acid, 2-(methacryloxy)ethyl isocyanate, 2-(acryloyloxy)ethyl isocyanate, and 2-(α-chloroacryloyloxy)ethylisocyanate.

The heat-resistant resin composition of the present invention may contain, as the thermal crosslinking agent (E), a thermal crosslinking agent having a structure represented by the following general formula (4) or a thermal crosslinking agent having a group represented by the following general formula (5). These thermal crosslinking agents (E) can crosslink the resin (A) or other additive components to improve the chemical resistance and hardness of the film after firing or after curing.

[Chemical Formula 11]

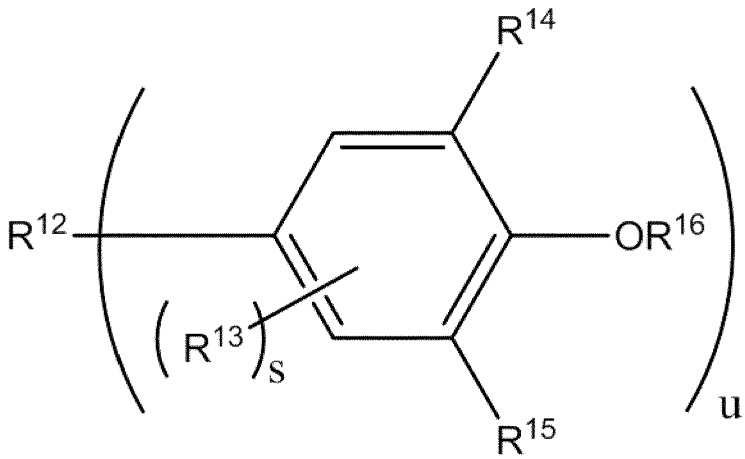

(4)

In the above general formula (4), $R^{12}$ represents a divalent to tetravalent linking group. $R^{13}$ represents a monovalent organic group having 1 to 20 carbon atoms, Cl, Br, I, or F. $R^{14}$ and $R^{15}$ represent $CH_2OR^{17}$ ($R^{17}$ is a hydrogen atom or a monovalent hydrocarbon group having 1 to 6 carbon atoms). $R^{16}$ represents a hydrogen atom, a methyl group, or an ethyl group. s represents an integer of 0 to 2, and u represents an integer of 2 to 4. A plurality of $R^{13}$ to $R^{16}$ may be the same or different from one another. Examples of the linking group $R^{12}$ will be shown below.

[Chemical Formula 12]

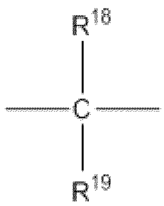
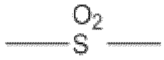
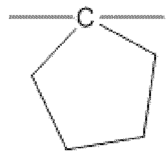
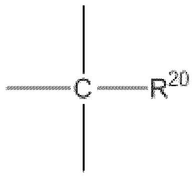

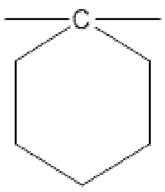
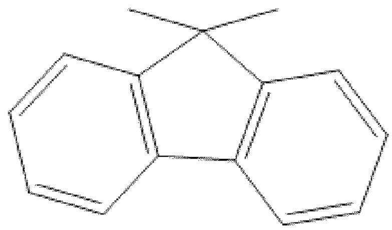
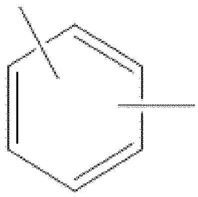
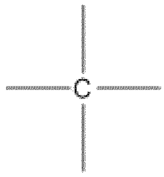

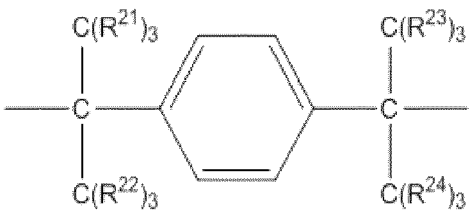
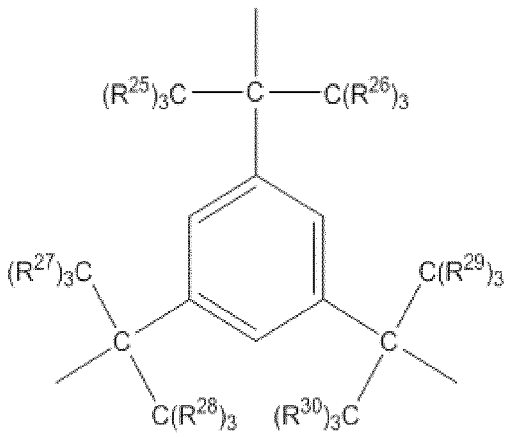
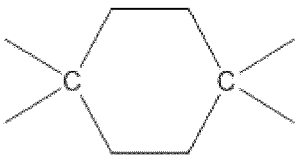

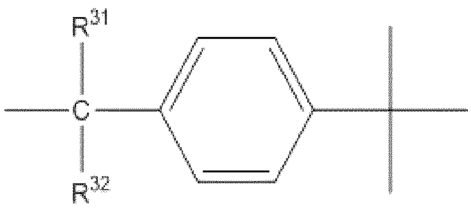
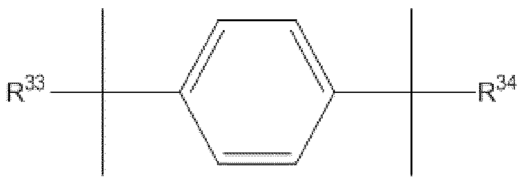

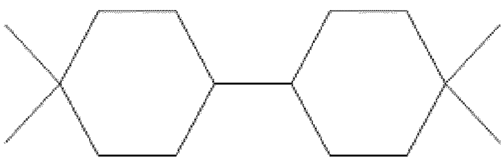
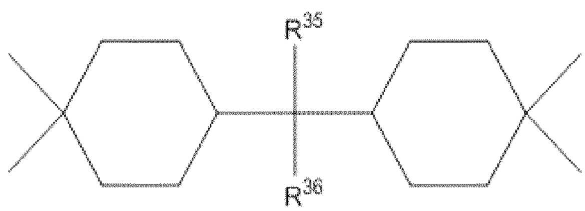

In the above formulas, $R^{18}$ to $R^{36}$ each independently represent a hydrogen atom, a monovalent organic group having 1 to 20 carbon atoms, Cl, Br, I, or F.

[Chemical Formula 13]

$$—N(CH_2OR^{37})_t(H)_v \quad (5)$$

In the above general formula (5), $R^{37}$ represents a hydrogen atom or a monovalent hydrocarbon group having 1 to 6 carbon atoms, t represents 1 or 2, and v represents 0 or 1. t + v is equal to 1 or 2.

In the above general formula (4), $R^{14}$ and $R^{15}$ represent $CH_2OR^{17}$ ($R^{17}$ is a hydrogen atom or a monovalent hydrocarbon group having 1 to 6 carbon atoms) which is a thermal crosslinking group. $R^{17}$ is preferably a monovalent hydrocarbon group having 1 to 4 carbon atoms to allow the thermal crosslinking agent of the above general formula (4) to maintain moderate degree of reactivity and excellent storage stability. In a heat-resistant resin composition containing the photoacid generator (D-1), or the photopolymerization initiator (D-2), and having photosensitivity, $R^{17}$ is more preferably a methyl group or an ethyl group.

In the thermal crosslinking agent having a structure represented by the above general formula (4), the purity of the thermal crosslinking agent is preferably 85% or more. When the purity is 85% or more, the storage stability is excellent, and the number of unreacted groups having water absorption properties can be reduced, so that the water absorption properties of the heat-resistant resin composition can be reduced. Examples of the method for obtaining a high-purity thermal crosslinking agent include recrystallization and distillation. The purity of the thermal crosslinking agent can be determined by a liquid chromatography. Preferable examples of the thermal crosslinking agent having a structure represented by the general formula (4) will be shown below.

[Chemical Formula 14]

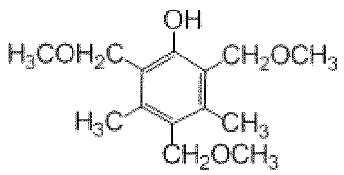

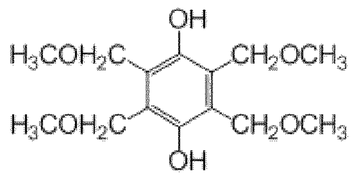

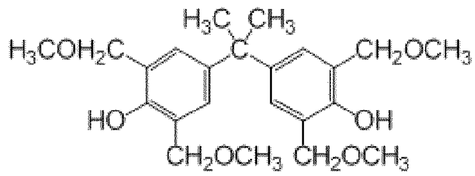

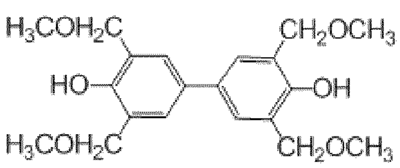

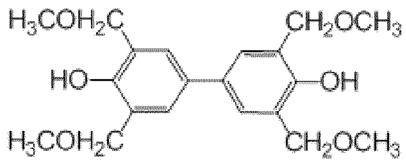

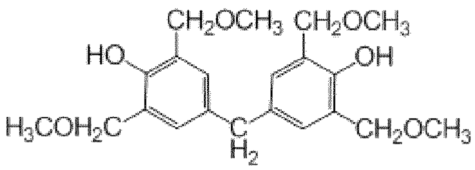

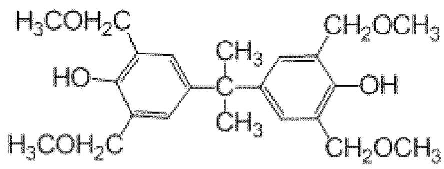

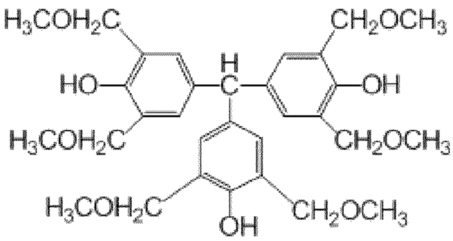

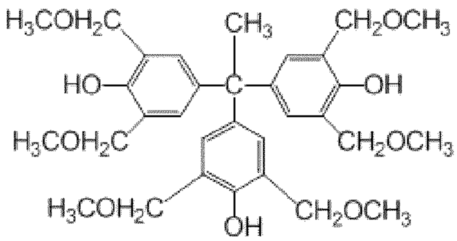

In the general formula (5), $R^{37}$ is a hydrogen atom or a monovalent hydrocarbon group having 1 to 6 carbon atoms, and preferably a monovalent hydrocarbon group having 1 to 4 carbon atoms. From the viewpoint of the stability of the compound and the storage stability in the resin composition, $R^{17}$ is preferably a methyl group or an ethyl group, and the number of ($CH_2OR^{37}$) groups contained in the compound is preferably 8 or less in the heat-resistant resin composition containing the photoacid generator (D-1), or the photopolymerization initiator (D-2), and having photosensitivity. Preferable examples of the thermal crosslinking agent having a group represented by the general formula (5) are shown below.

[Chemical Formula 15]

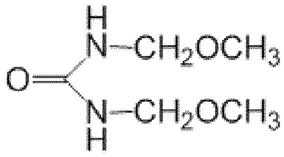

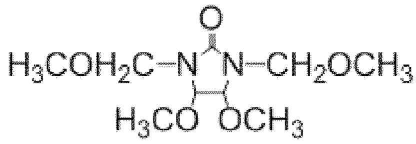

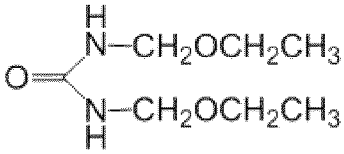

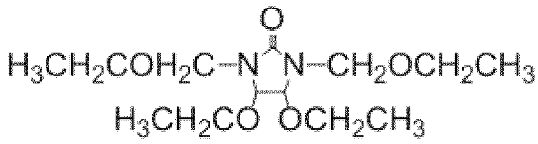

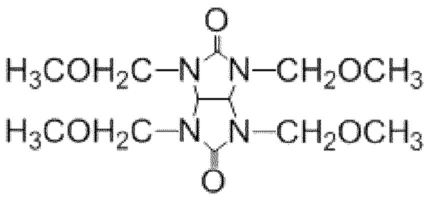

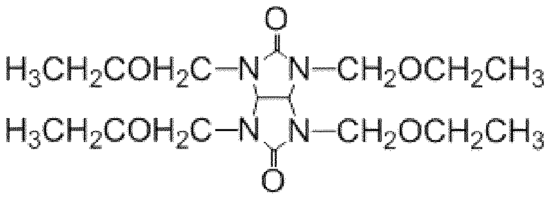

The content of the thermal crosslinking agent (E) is preferably 10 parts by mass or more and 100 parts by mass or less with respect to 100 parts by mass of the resin (A) . When the content of the thermal crosslinking agent (E) is 10 parts by mass or more, the film strength of the heat resistant resin film after firing or after curing is preferably high. When the content is 100 parts by mass or less, cracks resulting from increase in film stress caused by excessive crosslinking do not occur, which preferably provides an improvement in chemical resistance.

The heat-resistant resin composition of the present invention may further contain a thermal acid generator (F). The thermal acid generator (F) generates an acid on heating after development described later, so that it promotes a crosslinking reaction between the resin (A) and the thermal crosslinking agent (E) and also promotes the cyclization of the imide ring and oxazole ring in the resin (A). Therefore, the chemical resistance of the film after firing is improved, and film loss can be reduced. The acid to be generated from the thermal acid generator (F) is preferably a strong acid and, for example, arylsulfonic acids such as p-toluenesulfonic acid and benzenesulfonic acid, and alkylsulfonic acids such as methanesulfonic acid, ethanesulfonic acid, and butanesulfonic acid are preferable. In the present invention, the thermal acid generator (F) is preferably a sulfonic acid compound represented by the general formula (6) or (7), and may contain two or more of such compounds.

[Chemical Formula 16]

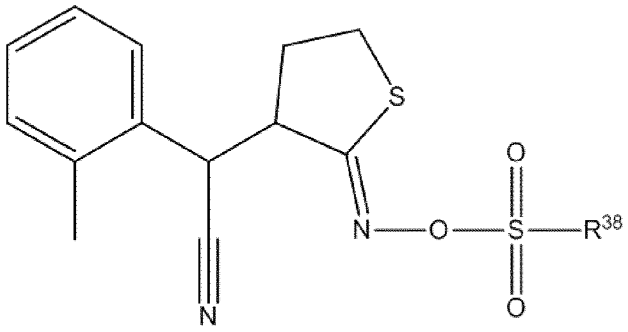

(6)

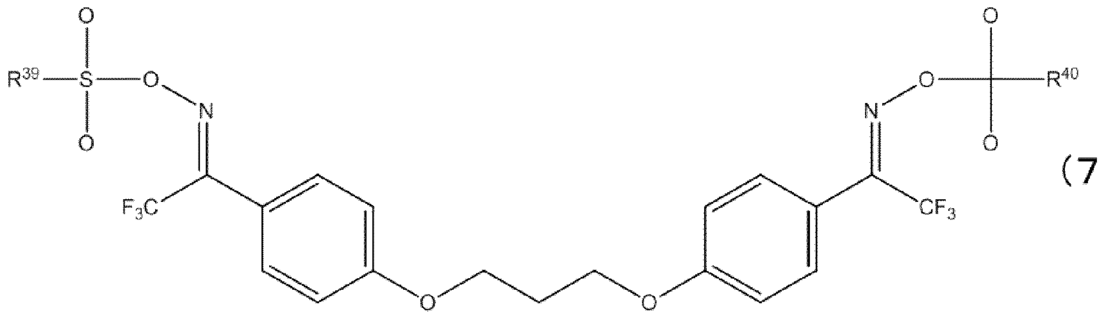

(7)

In the above general formulae (6) and (7), $R^{38}$ to $R^{40}$ each represent an alkyl group having 1 to 10 carbon atoms or a monovalent aromatic group having 7 to 12 carbon atoms. A part of the hydrogen atoms contained in the alkyl group and the aromatic group may be substituted, and examples of a substituent include an alkyl group and a carbonyl group.

Specific examples of the compound represented by the general formula (6) include the following compounds.

[Chemical Formula 17]

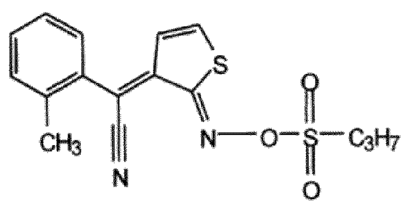

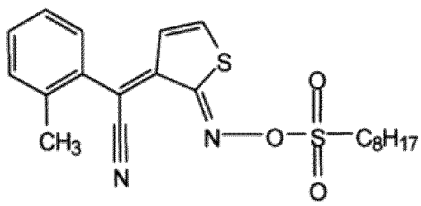

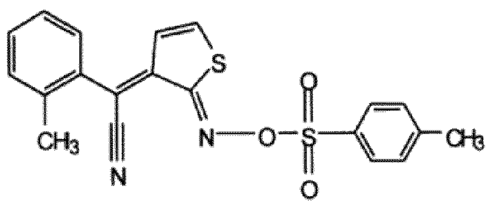

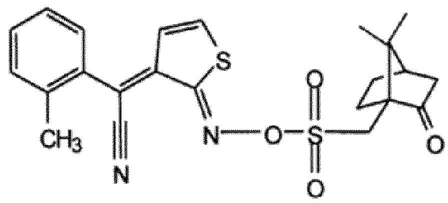

Specific examples of the compound represented by the general formula (7) include the following compounds.

[Chemical Formula 18]

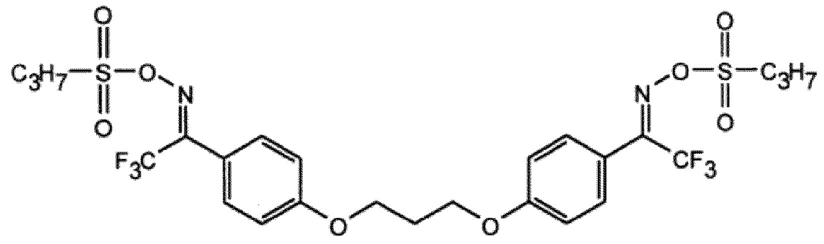

From the viewpoint of promoting the crosslinking reaction, the content of the thermal acid generator (F) is preferably 0.5 parts by mass or more with respect to 100 parts by mass of the resin (A) . When the content is 10 parts by mass or less, the cyclization of the imide ring or the oxazole ring due to excessive acid generation is not promoted excessively, so that alkali developability is improved, which is preferable.

If necessary, a compound having a phenolic hydroxyl group may be contained for the purpose of compensating the alkali developability of the heat-resistant resin composition having photosensitivity. Examples of the compound having a phenolic hydroxyl group include Bis-Z, BisOC-Z, BisOPP-Z, BisP-CP, Bis26X-Z, BisOTBP-Z, BisOCHP-Z, BisOCR-CP, BisP-MZ, BisP-EZ, Bis26X-CP, BisP-PZ, BisP-IPZ, BisCRIPZ, BisOCP-IPZ, BisOIPP-CP, Bis26X-IPZ, BisOTBP-CP, TekP-4HBPA(tetrakis P-DO-BPA), TrisPHAP, TrisP-PA, TrisP-PHBA, TrisP-SA, TrisOCR-PA, BisOFP-Z, BisRS-2P, BisPG-26X, BisRS-3P, BisOC-OCHP, BisPC-OCHP, Bis25X-OCHP, Bis26X-OCHP, BisOCHP-OC, Bis236T-OCHP, methylenetris-FR-CR, BisRS-26X, and BisRS-OCHP (product names, manufactured by Honshu Chemical Industry Co., Ltd.), BIR-OC, BIP-PC, BIR-PC, BIR-PTBP, BIRPCHP, BIP-BIOC-F, 4PC, BIR-BIPC-F, and TEP-BIP-A (product names, manufactured by Asahi Organic Chemicals Industry Co., Ltd.), 1,4-dihydroxynaphthalene, 1,5-dihydroxynaphthalene, 1,6-dihydroxynaphthalene, 1,7-dihydroxynaphthalene, 2,3-dihydroxynaphthalene, 2,6-dihydroxynaphthalene, 2,7-dihydroxynaphthalene, 2,4-dihydroxyquinoline, 2,6-dihydroxyquinoline, 2,3-dihydroxyquinoxaline, anthracene-1,2,10-triol, anthracene-1,8,9-triol, and 8-quinolinol. The heat-resistant resin composition which contains the compound having a phenolic hydroxyl group and has photosensitivity is hardly dissolved in an alkali developing solution before exposure, and is easily dissolved in the alkali developing solution upon exposure. Consequently, film loss caused by development is not reduced, and the development is completed in a short time. Therefore, the sensitivity is likely to be improved.

The content of the compound having a phenolic hydroxyl group is preferably 3 parts by mass or more and 40 parts by mass or less with respect to 100 parts by mass of the resin (A) . The above content causes the compound having a phenolic hydroxyl group to interact with a polymer, and provides high dissolution contrast between an exposed part and an unexposed part during development, thereby providing an improvement in sensitivity, which is preferable.

The heat-resistant resin composition of the present invention may contain a contact improver. Examples of the contact improver include silane coupling agents such as vinyl trimethoxysilane, vinyl triethoxysilane, epoxy cyclohexyl ethyl trimethoxysilane, 3-glycidoxypropyl trimethoxysilane, 3-glycidoxypropyl triethoxysilane, p-styryl trimethoxysilane, 3-aminopropyl trimethoxysilane, 3-aminopropyl triethoxysilane, and N-phenyl-3-aminopropyl trimethoxysilane, as well as titanium chelating agents, and aluminum chelating agents. Two or more thereof may be contained. When these contact improvers are contained, it is possible to enhance the contact property with a base substrate, such as a silicon wafer, ITO, $SiO_2$, or silicon nitride, when developing a coating film formed from a heat-resistant resin composition having photosensitivity. It is possible to improve resistance to oxygen plasma and UV ozone treatment used for washing. The content of the contact improver is preferably 0.1 to 10 parts by mass with respect to 100 parts by mass of the resin (A) . When the content is 0.1 parts by mass or more, the contact property with various substrates can be enhanced, which is preferable. When the content is 10 parts by mass or less, resistance to oxygen plasma and UV ozone treatment can be enhanced without generating the residue of a developed pattern in an excessive close contact state when developing a coating film, which is preferable.

The heat-resistant resin composition of the present invention may contain an adhesion improver. Examples of the adhesion improver include an alkoxysilane-containing aromatic amine compound, an aromatic amide compound, and a non-aromatic silane compound. Two or more thereof may be contained. When such compounds are contained, the adhesion property between a film and a substrate after firing or after curing can be improved. Specific examples of the alkoxysilane-containing aromatic amine compound and the aromatic amide compound will be shown below. In addition, compounds obtained by reacting an aromatic amine compound with an alkoxy group-containing silicon compound may also be used, and examples thereof include compounds obtained by reacting an aromatic amine compound with an alkoxysilane compound having a group which reacts with an amino group such as an epoxy group or a chloromethyl

group.

[Chemical Formula 19]

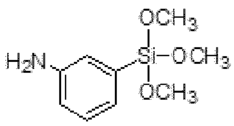
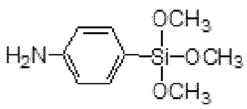
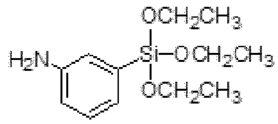
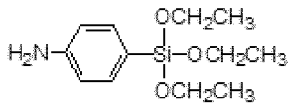
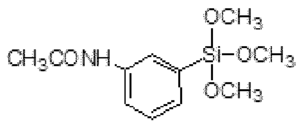
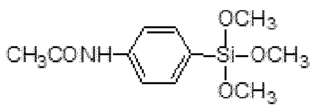
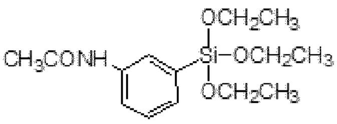
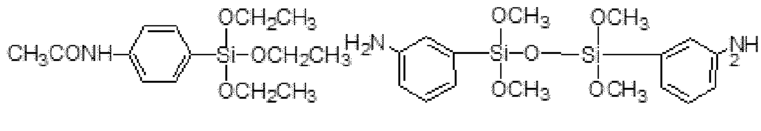
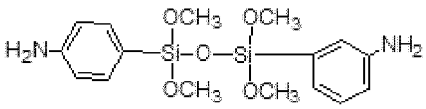
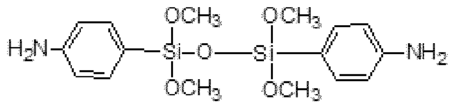
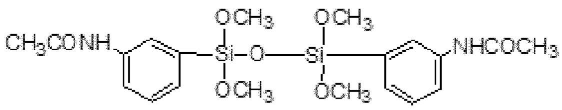
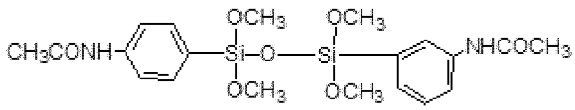
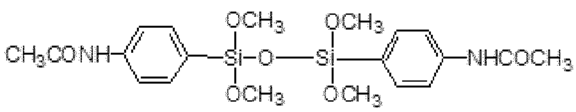

The total content of the adhesion improver is preferably 0.01 to 15 parts by mass with respect to 100 parts by mass of the resin (A). When the total content is 0.01 parts by mass or more, the adhesion property between a film and a substrate after firing or after curing can be improved, which is preferable. When the total content is 15 parts by mass or less, the adhesion property is improved without causing deterioration in alkali developability in an excessive close contact state, which is preferable.

The heat-resistant resin composition of the present invention may contain a surfactant, so that wettability with a support substrate can be improved.

Examples of the surfactant include fluorine-based surfactants such as Fluorad (product name, manufactured by Sumitomo 3M Ltd.), "MEGAFAC (registered trademark)" (manufactured by DIC Corporation)), and Sulfron (product name, manufactured by Asahi Glass Co., Ltd.); organic siloxane surfactants such as KP341 (product name, manufactured by Shin-Etsu Chemical Co., Ltd.), DBE (product name, manufactured by Chisso Corporation), GLANOL (product name, manufactured by Kyoeisha Chemical Co., Ltd.), and BYK (product name, manufactured by BYK-Chemie); and acrylic polymer surfactants such as Polyflow (product name, manufactured by Kyoeisha Chemical Co., Ltd.).

Next, a method for manufacturing the heat-resistant resin composition of the present invention will be described. For example, the heat-resistant resin composition can be obtained by dissolving the components (A) to (C) and, if necessary, the components (D) to (F), a dissolving regulator, a contact improver, an adhesion improver, or a surfactant. Examples of the dissolving method include stirring and heating. In the case of heating, the heating temperature is preferably set within a range not impairing the performance of the heat-resistant resin composition, and is usually from room temperature to 80°C. The order of dissolving the components is not particularly limited, and examples thereof include a method for dissolving the components one after another from a compound having lower solubility. A component that is likely to generate bubbles during dissolution by stirring, such as surfactants and some contact improvers, is lastly added after the other components are dissolved, which can prevent imperfect dissolution of the other components due to the generation of bubbles.

It is preferable that the obtained heat-resistant resin composition is filtered with a filter to remove dusts or

particles. The hole diameter of the filter is, for example, but is not limited to, 0.5 μm, 0.2 μm, 0.1 μm, 0.07 μm, 0.05 μm, 0.03 μm, 0.02 μm, 0.01 μm, and 0.005 μm. Examples of the material of the filter include polypropylene (PP), polyethylene (PE), nylon (NY), and polytetrafluoroethylene (PTFE), and PE and NY are preferable.

Next, a method for manufacturing a heat-resistant resin film using the heat-resistant resin composition of the present invention will be described with reference to examples.

The method for manufacturing a heat-resistant resin film of the present invention includes the step of applying the heat-resistant resin composition of the present invention on a support substrate and drying the heat-resistant resin composition to form a coating film; and heating the coating film.

Hereinafter, the method for manufacturing a heat-resistant resin film of the present invention will be described with reference to an exemplary case where the heat-resistant resin composition of the present invention is a heat-resistant resin composition containing the photoacid generator (D-1), or the photopolymerization initiator (D-2), and having photosensitivity.

First, the heat-resistant resin composition having photosensitivity is applied on a support substrate. Examples of the support substrate include, but not limited to, a silicon wafer, ceramics, gallium arsenide, metal, glass, a metal oxide insulation film, silicon nitride, and ITO. Examples of the coating method include spin coating using a spinner, spray coating, roll coating, and slit die coating. The coating film thickness varies depending on the coating technique, the solid content concentration and viscosity of the heat-resistant resin composition having photosensitivity, but the heat-resistant resin composition is generally applied so that the film thickness after drying is in the range of 0.1 to 150 μm.

Next, the support substrate on which the heat-resistant resin composition having photosensitivity is applied is dried to obtain a photosensitive coating film. The step is also referred to as a prebake step. The drying is preferably performed for one minute to several hours in the temperature range of 70 to 130°C using an oven, a hot plate, or infrared rays. When a hot plate is used, the coating film is put directly on the plate or held on jigs such as proxy pins fixed on the plate. There are various proxy pins of different materials including metal materials such as aluminum and stainless steel and synthetic resins such as polyimide resin and Teflon (registered trademark), but any types of proxy pins may be used if they have heat resistance . The height of the proxy pin varies depending on the size of the support substrate, the kind of the coating film, or the purpose of heating, but it is preferably 0.1 to 10 mm.

Next, a method for forming a pattern of a photosensitive coating film will be described. An actinic ray is applied to the coating film through a mask of an intended pattern. Examples of the actinic rays used for exposure include ultraviolet rays, visible rays, electron rays and X rays. In the present invention, the i-line (wavelength: 365 nm), the h-line (wavelength: 405 nm), and the g-line (wavelength: 436 nm) of a mercury lamp are preferably used. When the coating film has positive type photosensitivity, an exposed part is dissolved in a developing solution. When the applied film has negative type photosensitivity, an exposed part is cured, and becomes insoluble in a developing solution.

After the exposure, the exposed part is removed using a developing solution in order to form the pattern of the photosensitive coating film. The developing solution is preferably an aqueous solution of an alkaline compound such as a tetramethyl ammonium aqueous solution, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, or hexamethylenediamine. In some cases, at least one kind of polar solvents such as N-methyl-2-pyrrolidone, N,N-dimethylformamide, N,N-dimethylacetamide, dimethylsulfoxide, γ-butyrolactone, and dimethylacrylamide; alcohols such as methanol, ethanol, and isopropanol; esters such as ethyl lactate and propylene glycol monomethyl ether acetate; and ketones such as cyclopentanone, cyclohexanone, isobutyl ketone, and methyl isobutyl ketone may be added to the aqueous alkali solution. After the development, a rinsing treatment is generally performed using water. In the rinsing treatment, at least one kind of alcohols such as ethanol and isopropyl alcohol, and esters such as ethyl lactate, propylene glycol monomethyl ether acetate, and 3-methoxymethyl propanoate may be added to water.

After the development, the pattern of the obtained coating film is converted into a pattern of a heat-resistant resin film by heating in a temperature range of 200 to 500°C. The heating treatment is preferably performed for 5 minutes to 5 hours while a selected temperature is stepwisely raised, or a temperature is continuously raised in a certain selected temperature range. Examples include a method for performing heating treatment at each of 130°C, 200°C, and 350°C for 30 minutes each, and a method for linearly raising a temperature from room temperature to 320°C over 2 hours.

The pattern of the heat-resistant resin film formed of the heat-resistant resin composition of the present invention is suitably used for applications such as a surface protective film of a semiconductor element, an interlayer insulation film of a thin film inductor or multilayer wire for high density mounting, and an insulating layer of an organic electroluminescent element. The heat-resistant resin composition is preferably the heat-resistant resin composition containing the photoacid generator (D-1), or the photopolymerization initiator (D-2) and having photosensitivity from the viewpoint that pattern processing is likely to be improved.

The method for manufacturing an interlayer insulation film or a surface protective film of the present invention includes the steps of applying the heat-resistant resin composition of the present invention on a support substrate, and drying the heat-resistant resin composition to form a coating film; and heat-treating the coating film. Preferable conditions

for the method for manufacturing an interlayer insulation film or a surface protective film of the present invention are the same as those of the above-described method for manufacturing a heat-resistant resin film of the present invention. A step part such as a lower layer metal wire or an electrode pad in an interlayer insulation film or a surface protective film obtained by the method for manufacturing an interlayer insulation film or a surface protective film of the present invention is embedded to cover the interlayer insulation film or the surface protective film, so that sufficient electrical insulation properties and thermal shock resistance are likely to be obtained, which is preferable.

The method for manufacturing an electronic component or a semiconductor component of the present invention uses an interlayer insulation film or a surface protective film obtained by the method for manufacturing an interlayer insulation film or a surface protective film of the present invention. The use of the interlayer insulation film or the surface protective film is likely to improve the electrical insulation properties and thermal shock resistances of the electronic component and semiconductor component, and is likely to suppress deterioration in electrical characteristics to improve long-term reliability, which is preferable.

An example of a semiconductor component having a surface protective film obtained by the method for manufacturing an interlayer insulation film or a surface protective film of the present invention will be described with reference to Fig. 1. Fig. 1 is an enlarged cross-sectional view of a semiconductor component having a surface protective film obtained by the method for manufacturing an interlayer insulation film or a surface protective film of the present invention. A surface protective film 12 made of the heat-resistant resin composition of the present invention is formed on a semiconductor element 11. A lead electrode 13 supports and fixes the semiconductor element 11, and provides connection with an external wire. A sealing resin 14 is formed of resin such as epoxy resin in order to protect the semiconductor element 11 and the lead electrode 13 from factors such as external shock, temperature, or humidity. The role required for the surface protective film is to protect the semiconductor element from various damages such as filler attack, soft error, or thermal stress relaxation with the sealing resin. The heat-resistant resin composition of the present invention can be suitably used for the present application.

Next, an example of a semiconductor component having an interlayer insulation film obtained by the method for manufacturing an interlayer insulation film or a surface protective film of the present invention will be described with reference to the drawing. Fig. 2 is an enlarged cross-sectional view of a pad portion of a semiconductor component having an interlayer insulation film obtained by the method for manufacturing an interlayer insulation film or a surface protective film of the present invention. As shown in Fig. 2, a passivation film 23 is formed on an input/output Al pad 22 on a silicon wafer 21, and a via hole is formed in the passivation film 23. Furthermore, a pattern (interlayer insulation film 24) of a heat-resistant resin film formed of the heat-resistant resin composition of the present invention is formed on the passivation film 23. Furthermore, a metal (Cr, Ti, etc.) film 25 is formed so as to be connected to the Al pad 22, and a wire (Al, Cu, etc.) 26 is then formed by plating method. Next, a pattern (interlayer insulation film 27) of the heat-resistant resin composition of the present invention is formed on the wire (Al, Cu, etc.) 26. Next, a barrier metal 28 and a solder bump 30 are formed. Dicing is performed along the last scribe line 29 to divide silicon wafer 21 into respective chips. The role required for the interlayer insulation film is to alleviate the stress from the sealing resin during mounting and to prevent the damage of the low-k layer to improve the reliability of the semiconductor component. The heat-resistant resin composition of the present invention can be suitably used for the present application.

In the method for manufacturing an electronic component or a semiconductor component of the present invention, 2 to 10 interlayer insulation films are preferably used. The use of the two or more interlayer insulation films provides efficient insulation between conductors formed between the interlayer insulation films, which may be likely to provide an improvement in electrical characteristics. The use of the interlayer insulation films of 10 or less secures flatness, which may be likely to provide an improvement in processing accuracy.

An electronic component having a coil conductor including the heat-resistant resin composition of the present invention will be described with reference to Fig. 3, as an example of an electronic component obtained by the method for manufacturing an interlayer insulation film or a surface protective film of the present invention which uses 2 to 10 interlayer insulation films. Fig. 3 is an enlarged cross-sectional view of a multilayer structure portion obtained by alternately laminating an insulating layer and a coil conductor layer in an electronic component having a coil conductor. An interlayer insulation film 32a made of the heat-resistant resin composition of the present invention is formed on a support substrate 31, and a coil conductor layer 33a is formed on the interlayer insulation film 32a. Similarly, coil conductor layers 33b to 33d corresponding to interlayer insulation films 32b to 32d are formed, and interlayer insulation films 32e and 32f are formed. The role required for the interlayer insulation film is to secure the flatness of a coil conductor pattern forming surface in a laminated structure and to improve the processing accuracy of the coil conductor pattern in addition to the insulation between the coil conductor patterns. The heat-resistant resin composition of the present invention can be suitably used for the present application.

## EXAMPLES

Hereinafter, the present invention will be described with reference to Examples, but the present invention is

not limited thereto. Heat-resistant resin compositions in Examples were evaluated by the following methods.

(1) Evaluation of Drying Property

A heat-resistant resin composition was applied on an 8-inch silicon wafer using a spin coater so that a film thickness after drying was set to 10 μm. After applying the heat-resistant resin composition, the silicon wafer was dried at 100°C on a hot plate. The drying time was changed from 10 seconds to 180 seconds at an interval of 10 seconds, a dry state was investigated by finger touch inspection using tweezers, and the shortest drying time was taken as a minimum drying time. As the criterion for drying, the central portion of the silicon wafer on which the heat-resistant resin composition is applied is touched with tweezers, and a state where the heat-resistant resin composition does not adhere to the tweezers is taken as a dry state . The drying property was evaluated with the minimum drying time of 10 to 60 seconds as 3, of 60 to 120 seconds as 2, and of 120 seconds or longer as 1.

(2) Evaluation of step embedding properties

A heat-resistant resin composition was applied on a support substrate with steps by a coating method using the spin coater shown in (1) Evaluation of Drying Property, and dried to obtain a coating film. The coating film was charged into an inert oven (INH-21CD, manufactured by Koyo Thermo Systems Co., Ltd.). The temperature of the inert oven was raised to a curing temperature of 350°C over a period of 30 minutes, to heat-treat the coating film at 350°C for 60 minutes. Then, the inside of the oven was gradually cooled until it reached 50°C or lower, to produce a heat-resistant resin film. The thickness of the produced heat-resistant resin film covering the step part of the support substrate and the upper part of the embedded part was measured by observing the cross-section of the step part of the support substrate using a field emission type scanning electron microscope (S-4800, manufactured by Hitachi High-Technologies Corporation). The remaining portion excluding each side of 10 mm from the outer periphery of the support substrate was evenly divided into 30 parts as 30 measurement places . A step embedding ratio was calculated by the following formula.
Maximum height = average value of sum of height of step on support substrate and film thickness of heat-resistant resin film covering the step

Film thickness of embedded part = average value of film thickness at center of embedded part

step embedding ratio (%) = [maximum height/ film thickness of embedded part] × 100

Here, the step embedding ratio is preferably 90 to 100%, and more preferably 95 to 100%. The step embedding properties were evaluated with the step embedding ratio of 95 to 100% as 3, of 90 to 95% as 2, and 90% or less as 1.

A method for evaluating the step embedding properties will be described with reference to the drawing. Fig. 4 is an enlarged cross-sectional view of a heat-resistant resin film formed on a support substrate having step parts. As shown in Fig. 4, a heat resistant resin film 43 is formed on a support substrate 41 having a step part 42. A step embedding ratio is calculated from a maximum height 44 and a film thickness 45 of an embedded part to evaluate the step embedding properties.

In the support substrate with steps used for the evaluation, steps each having a depth of 4 μm were formed by forming an OFPR (product name, manufactured by Tokyo Ohka Kogyo Co., Ltd.) film as a photoresist on a 8-inch silicon wafer, forming a pattern according to photolithography, and performing dry etching using an etching apparatus (RIE-10N, manufactured by Samco Corporation) with the pattern as a mask, and peeling off the pattern made of OFPR with acetone.

(3) Regarding Boiling Point of Organic Solvent

The boiling points of organic solvents used in Examples and Comparative Examples of the present invention were quoted from the following documents "CRC Handbook of Chemistry and Physics" and "Aldrich Handbook of Fine Chemical and Laboratory Equipment".

<Synthesis Example 1: Synthesis of Hydroxyl Group-Containing Diamine Compound (HFHA)>

18.3 g (0.05 mol) of 2,2-bis(3-amino-4-hydroxyphenyl)hexafluoropropane (BAHF, manufactured by Central Glass Co., Ltd.) was dissolved in 100 mL of acetone and 17.4 g (0.3 mol) of propylene oxide (manufactured by Tokyo Chemical Industry Co., Ltd.), followed by cooling to -15°C. A solution in which 20.4 g (0.11 mol) of 3-nitrobenzoyl chloride (manufactured by Tokyo Chemical Industry Co., Ltd.) had been dissolved in 100 mL of acetone was added dropwise thereto. After the dropwise addition, the mixture was stirred at -15°C for 4 hours, and then heated to room temperature. The deposited white solid was separated by filtration, and then vacuum-dried at 50°C.

30 g of the obtained white solid was charged in a 300 mL stainless steel autoclave, and dispersed in 250 mL of methyl cellosolve, followed by adding 2 g of 5% palladium-carbon (manufactured by Wako Pure Chemical Industries, Ltd.). Hydrogen was introduced into the mixture with a balloon, and a reduction reaction was performed at room temperature. About 2 hours later, the reaction was terminated on confirmation that the balloon no longer shrank. After the termination of the reaction, the palladium compound as the catalyst was removed by filtration, followed by concentration with a rotary evaporator, to obtain a hydroxyl group-containing diamine compound (HFHA) represented by the following formula.

[Chemical Formula 20]

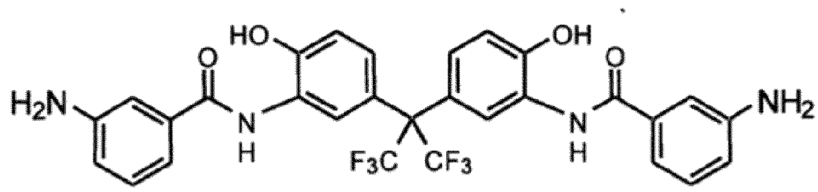

<Synthesis Example 2: Synthesis of Quinone Diazide Compound>

Under dry nitrogen flow, 21.22 g (0.05 mol) of TrisP-PA (product name, manufactured by Honshu Chemical Industry Co., Ltd.) and 26.8 g (0.1 mol) of 5-naphthoquinonediazidosulfonyl chloride (NAC-5, manufactured by Toyo Gosei Co., Ltd.) were dissolved in 450 g of 1,4-dioxane, and the temperature was adjusted to room temperature. 12.65 g of triethylamine, which had been mixed with 50 g of 1,4-dioxane, was added dropwise thereto so that the temperature of the system did not become equal to or higher than 35°C. After the dropwise addition, the mixture was stirred at 40°C for 2 hours. A triethylamine salt was filtered and the filtrate was poured into water. Then, the deposited precipitate was collected by filtration and further washed with 1L of 1% aqueous hydrochloric acid. Then, it was further washed with 2 L of water twice. The precipitate was dried in a vacuum dryer to obtain a quinone diazide compound represented by the following formula.

[Chemical Formula 21]

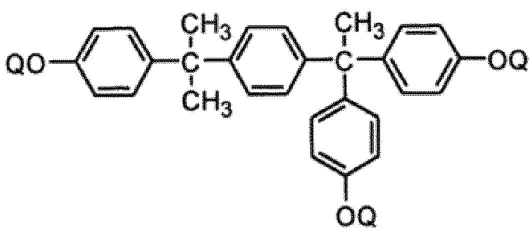

Q = 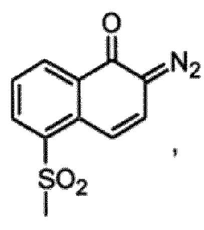 , H

2 : 1

[Example 1]

Under dry nitrogen flow, 51.3 g (0.085 mol) of HFHA obtained in Synthesis Example 1, 1.24 g (0.005 mol) of 1,3-bis(3-aminopropyl)tetramethyldisiloxane (SiDA, manufactured by Shin-Etsu Chemical Co., Ltd.), and 2.18 g (0.02 mol) of 3-aminophenol (manufactured by Tokyo Chemical Industry Co., Ltd.) were dissolved in 200 g of N-methyl-2-pyrrolidone (NMP) . 31.0 g (0.1 mol) of 3,3',4,4'-diphenyl ether tetracarboxylic dianhydride (ODPA, manufactured by

Manac Incorporated) was added thereto, followed by stirring at 40°C for 2 hours. Then, a solution prepared by diluting 7.14 g (0.06 mol) of dimethylformamide dimethyl acetal (DFA, manufactured by Mitsubishi Rayon Co., Ltd.) with 5 g of NMP was added dropwise thereto over 10 minutes. After the dropwise addition, stirring was continued at 40°C for 2 hours. After the termination of the stirring, the solution was poured into 2L of water, and a polymer solid precipitate was collected by filtration. Furthermore, the collected polymer solid was washed with 2L of water three times . The polymer solid was dried in a vacuum drier at 50°C for 72 hours to obtain a polyimide precursor.

10.0 g of the polyimide precursor and 0.04 g of Polyflow 77 (product name, manufactured by Kyoei Chemical Industry Co., Ltd.) as a surfactant were added into 7.8 g of 1,3-dimethyl-2-imidazolidinone (boiling point: 220°C), 9.7 g of ethyl lactate (boiling point; 154°C), and 1.9 g of propylene glycol monomethyl ether (boiling point: 120°C), followed by stirring, to obtain a varnish of a polyimide precursor composition, that is, a heat-resistant resin composition. Using the obtained varnish, a heat-resistant resin film was produced by spin coating method so that a film thickness after drying was set to 10 μm by the method described in the above (1), and the drying property and step embedding properties of the heat-resistant resin composition were evaluated.

[Example 2]

A heat-resistant resin composition was obtained in the same manner as in Example 1 except that the solvents were changed to 7.8 g of 1,3-dimethyl-2-imidazolidinone (boiling point: 220°C), 5.8 g of ethyl lactate (boiling point: 154°C), and 5.8 g of propylene glycol monomethyl ether (boiling point: 120°C) . A heat-resistant resin film was produced, and the drying property and step embedding properties of the heat-resistant resin composition were evaluated.

[Example 3]

A heat-resistant resin composition was obtained in the same manner as in Example 1 except that the solvents were changed to 7.8 g of 1,3-dimethyl-2-imidazolidinone (boiling point: 220°C), 1.9 g of ethyl lactate (boiling point: 154°C), and 9.7 g of propylene glycol monomethyl ether (boiling point: 120°C) . A heat-resistant resin film was produced, and the drying property and step embedding properties of the heat-resistant resin composition were evaluated.

[Example 4]

A heat-resistant resin composition was obtained in the same manner as in Example 1 except that the solvents were changed to 11.6 g of 1,3-dimethyl-2-imidazolidinone (boiling point: 220°C), 5.8 g of ethyl lactate (boiling point: 154°C), and 1.9 g of propylene glycol monomethyl ether (boiling point: 120°C) . A heat-resistant resin film was produced, and the drying property and step embedding properties of the heat-resistant resin composition were evaluated.

[Example 5]

A heat-resistant resin composition was obtained in the same manner as in Example 1 except that the solvents were changed to 11.6 g of 1,3-dimethyl-2-imidazolidinone (boiling point: 220°C), 3.9 g of ethyl lactate (boiling point: 154°C), and 3.9 g of propylene glycol monomethyl ether (boiling point: 120°C) . A heat-resistant resin film was produced, and the drying property and step embedding properties of the heat-resistant resin composition were evaluated.

[Example 6]

A heat-resistant resin composition was obtained in the same manner as in Example 1 except that the solvents were changed to 11.6 g of 1,3-dimethyl-2-imidazolidinone (boiling point: 220°C), 1.9 g of ethyl lactate (boiling point: 154°C), and 5.8 g of propylene glycol monomethyl ether (boiling point: 120°C) . A heat-resistant resin film was produced, and the drying property and step embedding properties of the heat-resistant resin composition were evaluated.

[Example 7]

A heat-resistant resin composition was obtained in the same manner as in Example 1 except that the solvents were changed to 3.9 g of 1,3-dimethyl-2-imidazolidinone (boiling point: 220°C), 13.6 g of ethyl lactate (boiling point: 154°C), and 1.9 g of propylene glycol monomethyl ether (boiling point: 120°C) . A heat-resistant resin film was produced, and the drying property and step embedding properties of the heat-resistant resin composition were evaluated.

[Example 8]

A heat-resistant resin composition was obtained in the same manner as in Example 1 except that the solvents were changed to 3.9 g of 1,3-dimethyl-2-imidazolidinone (boiling point: 220°C), 7.8 g of ethyl lactate (boiling point: 154°C), and 7.8 g of propylene glycol monomethyl ether (boiling point: 120°C) . A heat-resistant resin film was produced, and the drying property and step embedding properties of the heat-resistant resin composition were evaluated.

[Example 9]

A heat-resistant resin composition was obtained in the same manner as in Example 1 except that the solvents were changed to 3.9 g of 1,3-dimethyl-2-imidazolidinone (boiling point: 220°C), 1.9 g of ethyl lactate (boiling point: 154°C), and 13.6 g of propylene glycol monomethyl ether (boiling point: 120°C) . A heat-resistant resin film was produced, and the drying property and step embedding properties of the heat-resistant resin composition were evaluated.

[Example 10]

Under dry nitrogen flow, 32.9 g (0.09 mol) of BAHF was dissolved in 500 g of NMP. 31.0 g (0.1 mol) of ODPA was added thereto together with 50 g of NMP, followed by stirring at 30°C for 2 hours. Then, 2.18 g (0.02 mol) of 3-aminophenol (manufactured by Tokyo Chemical Industry Co., Ltd.) was added thereto, followed by stirring at 40°C for 2 hours. Furthermore, 5 g of pyridine (manufactured by Tokyo Chemical Industry Co., Ltd.) was diluted with toluene (manufactured by Tokyo Chemical Industry Co., Ltd., 30 g) to obtain a diluted solution. The diluted solution was added to the solution. A cooling tube was attached and a reaction was performed with the temperature of the solution kept at 120°C for 2 hours and further for 2 hours at 180°C while azeotropically removing water together with toluene out of the system. The temperature of the solution was lowered to room temperature, and the solution was poured into 3L of water to obtain a white powder. This powder was collected by filtration, and further washed with water three times. After he washing, the white powder was dried in a vacuum drier at 50°C for 72 hours to obtain a polyimide.

10.0 g of the polyimide resin and 0.04 g of Polyflow 77 (product name, manufactured by Kyoei Chemical Industry Co., Ltd.) as a surfactant were added into 7.8 g of 1,3-dimethyl-2-imidazolidinone (boiling point: 220°C), 5.8 g of ethyl lactate (boiling point: 154°C), and 5.8 g of propylene glycol monomethyl ether (boiling point: 120°C), followed by stirring, to obtain a varnish of a heat-resistant resin composition of the polyimide, that is, a heat-resistant resin composition. Using the obtained varnish, by the methods described in the above (1) and (2), a heat-resistant resin film was produced, and the drying property and step embedding properties of the heat-resistant resin composition were evaluated.

[Example 11]

Under dry nitrogen flow, 18.3 g (0.05 mol) of BAHF was dissolved in 50 g of NMP and 26.4 g (0.3 mol) of glycidyl methyl ether, and the solution temperature was cooled to -15°C. A solution prepared by dissolving 7.4 g (0.025 mol) of diphenyl ether dicarboxylic acid dichloride (manufactured by Nihon Nohyaku Co., Ltd.) and 5.1 g (0.025 mol) of isophthalic acid chloride (manufactured by Tokyo Chemical Industry Co., Ltd.) in 25 g of $\gamma$-butyrolactone was added dropwise thereto so that the internal temperature of the solution did not exceed 0°C. After the dropwise addition, stirring was continued at -15°C for 6 hours. After the termination of the reaction, the solution was poured into 3L of water containing 10% by mass of methanol to obtain a white precipitate, and the white precipitate was collected. The precipitate was collected by filtration, washed with water three times, and then dried in a vacuum dryer at 50°C for 72 hours to obtain a polybenzoxazole precursor.

10.0 g of the polybenzoxazole precursor and 0.04 g of Polyflow 77 (product name, manufactured by Kyoei Chemical Industry Co., Ltd.) as a surfactant were added into 7.8 g of 1,3-dimethyl-2-imidazolidinone (boiling point: 220°C), 5.8 g of ethyl lactate (boiling point: 154°C), and 5.8 g of propylene glycol monomethyl ether (boiling point: 120°C), followed by stirring, to obtain a varnish of a polybenzoxazole precursor composition, that is, a heat-resistant resin composition. Using the obtained varnish, by the methods described in the above (1) and (2), a heat-resistant resin film was produced, and the drying property and step embedding properties of the heat-resistant resin composition were evaluated.

[Example 12]

A heat-resistant resin composition was obtained in the same manner as in Example 1 except that the solvents were changed to 11.6 g of N,N-dimethylpropyleneurea (boiling point: 246°C), 3.9 g of ethyl lactate (boiling point: 154°C), and 3.9 g of propylene glycol monomethyl ether (boiling point: 120°C). A heat-resistant resin film was produced, and the drying property and step embedding properties of the heat-resistant resin composition were evaluated.

[Example 13]

A heat-resistant resin composition was obtained in the same manner as in Example 1 except that the solvents were changed to 7.8 g of N,N-dimethylpropyleneurea (boiling point: 246°C), 5.8 g of ethyl lactate (boiling point: 154°C), and 5.8 g of propylene glycol monomethyl ether (boiling point: 120°C). A heat-resistant resin film was produced, and the drying property and step embedding properties of the heat-resistant resin composition were evaluated.

[Example 14]

A heat-resistant resin composition was obtained in the same manner as in Example 1 except that the solvents were changed to 3.9 g of N,N-dimethylpropyleneurea (boiling point: 246°C), 7.8 g of ethyl lactate (boiling point: 154°C), and 7.8 g of propylene glycol monomethyl ether (boiling point: 120°C). A heat-resistant resin film was produced, and the drying property and step embedding properties of the heat-resistant resin composition were evaluated.

[Example 15]

A heat-resistant resin composition was obtained in the same manner as in Example 1 except that the solvents were changed to 11.6 g of 3-methoxy-N,N-dimethylpropionamide (boiling point: 216°C), 3.9 g of ethyl lactate (boiling point: 154°C), and 3.9 g of propylene glycol monomethyl ether (boiling point: 120°C). A heat-resistant resin film was produced, and the drying property and step embedding properties of the heat-resistant resin composition were evaluated.

[Example 16]

A heat-resistant resin composition was obtained in the same manner as in Example 1 except that the solvents were changed to 7.8 g of 3-methoxy-N, N-dimethylpropionamide (boiling point: 216°C), 5.8 g of ethyl lactate (boiling point: 154°C), and 5.8 g of propylene glycol monomethyl ether (boiling point: 120°C) . A heat-resistant resin film was produced, and the drying property and step embedding properties of the heat-resistant resin composition were evaluated.

[Example 17]

A heat-resistant resin composition was obtained in the same manner as in Example 1 except that the solvents were changed to 3.9 g of 3-methoxy-N, N-dimethylpropionamide (boiling point: 216°C), 7.8 g of ethyl lactate (boiling point: 154°C), and 7.8 g of propylene glycol monomethyl ether (boiling point: 120°C) . A heat-resistant resin film was produced, and the drying property and step embedding properties of the heat-resistant resin composition were evaluated.

[Example 18]

A heat-resistant resin composition was obtained in the same manner as in Example 1 except that the solvents were changed to 11.6 g of delta valerolactone (boiling point: 230°C), 3.9 g of ethyl lactate (boiling point: 154°C), and 3.9 g of propylene glycol monomethyl ether (boiling point: 120°C). A heat-resistant resin film was produced, and the drying property and step embedding properties of the heat-resistant resin composition were evaluated.

[Example 19]

A heat-resistant resin composition was obtained in the same manner as in Example 1 except that the solvents were changed to 7.8 g of delta valerolactone (boiling point: 230°C), 5.8 g of ethyl lactate (boiling point: 154°C), and 5.8 g of propylene glycol monomethyl ether (boiling point: 120°C). A heat-resistant resin film was produced, and the drying property and step embedding properties of the heat-resistant resin composition were evaluated.

[Example 20]

A heat-resistant resin composition was obtained in the same manner as in Example 1 except that the solvents were changed to 3.9 g of delta valerolactone (boiling point: 230°C), 7.8 g of ethyl lactate (boiling point: 154°C), and 7.8 g of propylene glycol monomethyl ether (boiling point: 120°C). A heat-resistant resin film was produced, and the drying property and step embedding properties of the heat-resistant resin composition were evaluated.

[Example 21]

A heat-resistant resin composition was obtained in the same manner as in Example 1 except that the solvents were changed to 11.6 g of 1,3-dimethyl-2-imidazolidinone (boiling point: 220°C), 3.9 g of diethylene glycol ethyl methyl ether (boiling point: 176°C), and 3.9 g of propylene glycol monomethyl ether (boiling point: 120°C) . A heat-resistant resin film was produced, and the drying property and step embedding properties of the heat-resistant resin composition were evaluated.

[Example 22]

A heat-resistant resin composition was obtained in the same manner as in Example 1 except that the solvents were changed to 7.8 g of 1,3-dimethyl-2-imidazolidinone (boiling point: 220°C), 5.8 g of diethylene glycol ethyl methyl ether (boiling point: 176°C), and 5.8 g of propylene glycol monomethyl ether (boiling point: 120°C) . A heat-resistant resin film was produced, and the drying property and step embedding properties of the heat-resistant resin composition were evaluated.

[Example 23]

A heat-resistant resin composition was obtained in the same manner as in Example 1 except that the solvents were changed to 3.9 g of 1,3-dimethyl-2-imidazolidinone (boiling point: 220°C), 7.8 g of diethylene glycol ethyl methyl ether (boiling point: 176°C), and 7.8 g of propylene glycol monomethyl ether (boiling point: 120°C) . A heat-resistant resin film was produced, and the drying property and step embedding properties of the heat-resistant resin composition were evaluated.

[Example 24]

10 g of the polyimide resin obtained in Example 10 and 0.04 g of Polyflow 77 (product name, manufactured by Kyoei Chemical Industry Co., Ltd.) as a surfactant were added into 7.8 g of 1,3-dimethyl-imidazolidinone (boiling point: 220°C), 5.8 g of diethylene glycol ethyl methyl ether (boiling point 176°C), and 5.8 g of propylene glycol monomethyl ether (boiling point: 120°C), followed by stirring, to obtain a varnish of a polyimide composition, that is, a heat-resistant resin composition. Using the obtained varnish, by the methods described in the above (1) and (2), a heat-resistant resin film was produced, and the drying property and step embedding properties of the heat-resistant resin composition were evaluated.

[Example 25]

10 g of the polybenzoxazole precursor resin obtained in Example 11 and 0.04 g of Polyflow 77 (product name, manufactured by Kyoei Chemical Industry Co., Ltd.) as a surfactant were added into 7.8 g of 1,3-dimethyl-2-imidazolidinone (boiling point: 220°C), 5.8 g of diethylene glycol ethyl methyl ether (boiling point: 176°C), and 5.8 g of propylene glycol monomethyl ether (boiling point: 120°C), followed by stirring, to obtain a varnish of a polybenzoxazole precursor composition, that is, a heat-resistant resin composition. Using the obtained varnish, by the methods described in the above (1) and (2), a heat-resistant resin film was produced, and the drying property and step embedding properties of the heat-resistant resin composition were evaluated.

[Example 26]

A heat-resistant resin composition was obtained in the same manner as in Example 1 except that the solvents were changed to 7.8 g of N,N-dimethylpropyleneurea (boiling point: 246°C), 5.8 g of diethylene glycol ethyl methyl ether (boiling point: 176°C), and 5.8 g of propylene glycol monomethyl ether (boiling point: 120°C) . A heat-resistant resin film was produced, and the drying property and step embedding properties of the heat-resistant resin composition were evaluated.

[Example 27]

A heat-resistant resin composition was obtained in the same manner as in Example 1 except that the solvents were changed to 7.8 g of 3-methoxy-N, N-dimethylpropionamide (boiling point: 216°C), 5.8 g of diethylene glycol ethyl methyl ether (boiling point: 176°C), and 5.8 g of propylene glycol monomethyl ether (boiling point: 120°C) . A heat-resistant resin film was produced, and the drying property and step embedding properties of the heat-resistant resin

composition were evaluated.

[Example 28]

A heat-resistant resin composition was obtained in the same manner as in Example 1 except that the solvents were changed to 7.8 g of delta valerolactone (boiling point: 230°C), 5.8 g of diethylene glycol ethyl methyl ether (boiling point: 176°C), and 5.8 g of propylene glycol monomethyl ether (boiling point: 120°C). A heat-resistant resin film was produced, and the drying property and step embedding properties of the heat-resistant resin composition were evaluated.

[Example 29]

10 g of the polyimide precursor obtained in Example 1, 3 g of the quinone diazide compound obtained in Synthesis Example 2, and 0.04 g of Polyflow 77 (manufactured by Kyoeisha Chemical Co., Ltd.) as a surfactant were added into 7.8 g of delta valerolactone (boiling point: 230°C), 5.8 g of ethyl lactate (boiling point: 154°C), and 5.8 g of propylene glycol monomethyl ether (boiling point: 120°C), followed by stirring, to obtain a varnish of a polyimide precursor composition having positive type photosensitivity, that is, a heat-resistant resin composition. With the methods described in the above (1) and (2) using the obtained varnish, a heat-resistant resin film was produced, and the drying property and step embedding properties of the heat-resistant resin composition were evaluated.

[Example 30]

10 g of the polyimide precursor obtained in Example 1, 3 g of the quinone diazide compound obtained in Synthesis Example 2, and 0.04 g of Polyflow 77 (manufactured by Kyoeisha Chemical Co., Ltd.) as a surfactant were added into 7.8 g of delta valerolactone (boiling point: 230°C), 5.8 g of diethylene glycol ethyl methyl ether (boiling point: 176°C), and 5.8 g of propylene glycol monomethyl ether (boiling point: 120°C), followed by stirring, to obtain a varnish of a polyimide precursor composition having positive type photosensitivity, that is, a heat-resistant resin composition. With the methods described in the above (1) and (2) using the obtained varnish, a heat-resistant resin film was produced, and the drying property and step embedding properties of the heat-resistant resin composition were evaluated.

[Example 31]

10 g of the polyimide obtained in Example 10, 3 g of the quinone diazide compound obtained in Synthesis Example 2, and 0.04 g of Polyflow 77 (manufactured by Kyoeisha Chemical Co., Ltd.) as a surfactant were added into 7.8 g of delta valerolactone (boiling point: 230°C), 5.8 g of ethyl lactate (boiling point: 154°C), and 5.8 g of propylene glycol monomethyl ether (boiling point: 120°C), followed by stirring, to obtain a varnish of a polyimide composition having positive type photosensitivity, that is, a heat-resistant resin composition. With the methods described in the above (1) and (2) using the obtained varnish, a heat-resistant resin film was produced, and the drying property and step embedding properties of the heat-resistant resin composition were evaluated.

[Example 32]

10 g of the polybenzoxazole precursor obtained in Example 11, 3 g of the quinone diazide compound obtained in Synthesis Example 2, and 0.04 g of Polyflow 77 (manufactured by Kyoeisha Chemical Co., Ltd.) as a surfactant were added into 7.8 g of delta valerolactone (boiling point: 230°C), 5.8 g of ethyl lactate (boiling point: 154°C), and 5.8 g of propylene glycol monomethyl ether (boiling point: 120°C), followed by stirring, to obtain a varnish of a polybenzoxazole precursor composition having positive type photosensitivity, that is, a heat-resistant resin composition. With the methods described in the above (1) and (2) using the obtained varnish, a heat-resistant resin film was produced, and the drying property and step embedding properties of the heat-resistant resin composition were evaluated.

[Example 33]

A heat-resistant resin composition was obtained in the same manner as in Example 1 except that the solvents were changed to 7.8 g of 1,3-dimethyl-2-imidazolidinone (boiling point: 220°C), 5.8 g of N,N-dimethylisobutyramide (boiling point: 175°C), and 5.8 g of propylene glycol monomethyl ether (boiling point: 120°C) . A heat-resistant resin film was produced, and the drying property and step embedding properties of the heat-resistant resin composition were evaluated.

[Example 34]

A heat-resistant resin composition was obtained in the same manner as in Example 1 except that the solvents were changed to 7.8 g of N,N-dimethylpropyleneurea (boiling point: 246°C), 5.8 g of N,N-dimethylisobutyramide (boiling point: 175°C), and 5.8 g of propylene glycol monomethyl ether (boiling point: 120°C). A heat-resistant resin film was produced, and the drying property and step embedding properties of the heat-resistant resin composition were evaluated.

[Example 35]

A heat-resistant resin composition was obtained in the same manner as in Example 1 except that the solvents were changed to 7.8 g of 3-methoxy-N, N-dimethylpropionamide (boiling point: 216°C), 5.8 g of N,N-dimethylisobutyramide (boiling point: 175°C), and 5.8 g of propylene glycol monomethyl ether (boiling point: 120°C) . A heat-resistant resin film was produced, and the drying property and step embedding properties of the heat-resistant resin composition were evaluated.

[Example 36]

A heat-resistant resin composition was obtained in the same manner as in Example 1 except that the solvents were changed to 7.8 g of delta valerolactone (boiling point: 230°C), 5.8 g of N,N-dimethylisobutyramide (boiling point: 175°C), and 5.8 g of propylene glycol monomethyl ether (boiling point: 120°C) . A heat-resistant resin film was produced, and the drying property and step embedding properties of the heat-resistant resin composition were evaluated.

[Example 37]

A heat-resistant resin composition was obtained in the same manner as in Example 1 except that the solvents were changed to 7.8 g of 1,3-dimethyl-2-imidazolidinone (boiling point: 220°C), 5.8 g of gamma butyrolactone (boiling point: 203°C), and 5.8 g of propylene glycol monomethyl ether (boiling point: 120°C). A heat-resistant resin film was produced, and the drying property and step embedding properties of the heat-resistant resin composition were evaluated.

[Example 38]

A heat-resistant resin composition was obtained in the same manner as in Example 1 except that the solvents were changed to 7.8 g of N,N-dimethylpropyleneurea (boiling point: 246°C), 5.8 g of gamma butyrolactone (boiling point: 203°C), and 5.8 g of propylene glycol monomethyl ether (boiling point: 120°C) . A heat-resistant resin film was produced, and the drying property and step embedding properties of the heat-resistant resin composition were evaluated.

[Example 39]

A heat-resistant resin composition was obtained in the same manner as in Example 1 except that the solvents were changed to 7.8 g of 3-methoxy-N,N-dimethylpropionamide (boiling point: 216°C), 5.8 g of gamma butyrolactone (boiling point: 203°C), and 5.8 g of propylene glycol monomethyl ether (boiling point: 120°C). A heat-resistant resin film was produced, and the drying property and step embedding properties of the heat-resistant resin composition were evaluated.

[Example 40]

A heat-resistant resin composition was obtained in the same manner as in Example 1 except that the solvents were changed to 7.8 g of delta valerolactone (boiling point: 230°C), 5.8 g of gamma butyrolactone (boiling point: 203°C), and 5.8 g of propylene glycol monomethyl ether (boiling point: 120°C). A heat-resistant resin film was produced, and the drying property and step embedding properties of the heat-resistant resin composition were evaluated.

[Comparative Example 41]

A heat-resistant resin composition was obtained in the same manner as in Example 1 except that the solvents were changed to 9.7 g of 1,3-dimethyl-2-imidazolidinone (boiling point: 220°C) and 9.7 g of propylene glycol monomethyl ether (boiling point: 120°C) . A heat-resistant resin film was produced, and the drying property and step embedding properties of the heat-resistant resin composition were evaluated.

[Comparative Example 1]

A heat-resistant resin composition was obtained in the same manner as in Example 1 except that the solvents were changed to 15.5 g of 1,3-dimethyl-2-imidazolidinone (boiling point: 220°C), 1.9 g of ethyl lactate (boiling point: 154°C), and 1.9 g of propylene glycol monomethyl ether (boiling point: 120°C) . A heat-resistant resin film was produced, and the drying property and step embedding properties of the heat-resistant resin composition were evaluated.

[Comparative Example 2]

A heat-resistant resin composition was obtained in the same manner as in Example 1 except that the solvents were changed to 15.5 g of N,N-dimethylpropyleneurea (boiling point: 246°C), 1.9 g of ethyl lactate (boiling point: 154°C), and 1.9 g of propylene glycol monomethyl ether (boiling point: 120°C). A heat-resistant resin film was produced, and the drying property and step embedding properties of the heat-resistant resin composition were evaluated.

[Comparative Example 3]

A heat-resistant resin composition was obtained in the same manner as in Example 1 except that the solvents were changed to 15.5 g of 3-methoxy-N,N-dimethylpropionamide (boiling point: 216°C), 1.9 g of ethyl lactate (boiling point: 154°C), and 1.9 g of propylene glycol monomethyl ether (boiling point: 120°C). A heat-resistant resin film was produced, and the drying property and step embedding properties of the heat-resistant resin composition were evaluated.

[Comparative Example 4]

A heat-resistant resin composition was obtained in the same manner as in Example 1 except that the solvents were changed to 15.5 g of delta valerolactone (boiling point: 230°C), 1.9 g of ethyl lactate (boiling point: 154°C), and 1.9 g of propylene glycol monomethyl ether (boiling point: 120°C). A heat-resistant resin film was produced, and the drying property and step embedding properties of the heat-resistant resin composition were evaluated.

[Comparative Example 5]

A heat-resistant resin composition was obtained in the same manner as in Example 1 except that the solvents were changed to 15.5 g of diethylene glycol ethyl methyl ether (boiling point: 176°C) and 3.9 g of propylene glycol monomethyl ether (boiling point: 120°C). A heat-resistant resin film was produced, and the drying property and step embedding properties of the heat-resistant resin composition were evaluated.

[Comparative Example 6]

A heat-resistant resin composition was obtained in the same manner as in Example 1 except that the solvents were changed to 9.7 g of diethylene glycol ethyl methyl ether (boiling point: 176°C) and 9.7 g of propylene glycol monomethyl ether (boiling point: 120°C). A heat-resistant resin film was produced, and the drying property and step embedding properties of the heat-resistant resin composition were evaluated.

[Comparative Example 7]

A heat-resistant resin composition was obtained in the same manner as in Example 1 except that the solvents were changed to 3.9 g of diethylene glycol ethyl methyl ether (boiling point: 176°C) and 15.5 g of propylene glycol monomethyl ether (boiling point: 120°C). A heat-resistant resin film was produced, and the drying property and step embedding properties of the heat-resistant resin composition were evaluated.

[Comparative Example 8]

A heat-resistant resin composition was obtained in the same manner as in Example 1 except that the solvents were changed to 11.6 g of gamma butyrolactone (boiling point: 203°C), 3.9 g of diethylene glycol ethyl methyl ether (boiling point: 176°C), and 3.9 g of propylene glycol monomethyl ether (boiling point: 120°C). A heat-resistant resin film was produced, and the drying property and step embedding properties of the heat-resistant resin composition were evaluated.

[Comparative Example 9]

A heat-resistant resin composition was obtained in the same manner as in Example 1 except that the solvents were changed to 7.8 g of gamma butyrolactone (boiling point: 203°C), 5.8 g of diethylene glycol ethyl methyl ether (boiling point: 176°C), and 5.8 g of propylene glycol monomethyl ether (boiling point: 120°C). A heat-resistant resin film was produced, and the drying property and step embedding properties of the heat-resistant resin composition were evaluated.

[Comparative Example 10]

A heat-resistant resin composition was obtained in the same manner as in Example 1 except that the solvents were changed to 3.9 g of gamma butyrolactone (boiling point: 203°C), 7.8 g of diethylene glycol ethyl methyl ether (boiling point: 176°C), and 7.8 g of propylene glycol monomethyl ether (boiling point: 120°C). A heat-resistant resin film was produced, and the drying property and step embedding properties of the heat-resistant resin composition were evaluated.

[Comparative Example 11]

A heat-resistant resin composition was obtained in the same manner as in Example 1 except that the solvent was changed to 19.4 g of gamma butyrolactone (boiling point: 203°C) . Aheat-resistant resin film was produced, and the drying property and step embedding properties of the heat-resistant resin composition were evaluated.

[Comparative Example 12]

A heat-resistant resin composition was obtained in the same manner as in Example 1 except that the solvent was changed to 19.4 g of N-methylpyrrolidone (boiling point: 204°C). A heat-resistant resin film was produced, and the drying property and step embedding properties of the heat-resistant resin composition were evaluated.

The above compositions and evaluation results of Examples 1 to 14 are shown in Table 1; those of Examples 15 to 27 are shown in Table 2; those of Examples 28 to 41 are shown in Table 3; and those of Comparative Examples 1 to 12 are shown in Table 4.

[Table 1]

| Number | Resin (A) | Organic solvent (B) | Organic solvent (C-1) | Organic solvent (C-2) | Photosensitizer (D) | Other components | Drying property | Step embedding properties |
|---|---|---|---|---|---|---|---|---|
| Example 1 | Polyimide precursor | DMI<br>40% by mass | EL<br>50% by mass | PGME<br>10% by mass | - | Polyflow 77 | 3 | 3 |
| Example 2 | Polyimide precursor | DMI<br>40% by mass | EL<br>30% by mass | PGME<br>30% by mass | - | Polyflow 77 | 3 | 3 |
| Example 3 | Polyimide precursor | DMI<br>40% by mass | EL<br>10% by mass | PGME<br>50% by mass | - | Polyflow 77 | 3 | 3 |
| Example 4 | Polyimide precursor | DMI<br>60% by mass | EL<br>30% by mass | PGME<br>10% by mass | - | Polyflow 77 | 2 | 3 |
| Example 5 | Polyimide precursor | DMI<br>60% by mass | EL<br>20% by mass | PGME<br>20% by mass | - | Polyflow 77 | 3 | 3 |
| Example 6 | Polyimide precursor | DMI<br>60% by mass | EL<br>10% by mass | PGME<br>30% by mass | - | Polyflow 77 | 3 | 3 |
| Example 7 | Polyimide precursor | DMI<br>20% by mass | EL<br>70% by mass | PGME<br>10% by mass | - | Polyflow 77 | 3 | 2 |
| Example 8 | Polyimide precursor | DMI<br>20% by mass | EL<br>40% by mass | PGME<br>40% by mass | - | Polyflow 77 | 3 | 2 |
| Example 9 | Polyimide precursor | DMI<br>20% by mass | EL<br>10% by mass | PGME<br>70% by mass | - | Polyflow 77 | 3 | 2 |

(continued)

| Number | Resin (A) | Organic solvent (B) | Organic solvent (C-1) | Organic solvent (C-2) | Photosensitizer (D) | Other components | Drying property | Step embedding properties |
|---|---|---|---|---|---|---|---|---|
| Example 10 | Polyimide | DMI<br>40% by mass | EL<br>30% by mass | PGME<br>30% by mass | - | Polyflow 77 | 3 | 3 |
| Example 11 | Polybenzoxazole precursor | DMI<br>40% by mass | EL<br>30% by mass | PGME<br>30% by mass | - | Polyflow 77 | 3 | 3 |
| Example 12 | Polyimide precursor | DMPU<br>60% by mass | EL<br>20% by mass | PGME<br>20% by mass | - | Polyflow 77 | 2 | 3 |
| Example 13 | Polyimide precursor | DMPU<br>40% by mass | EL<br>30% by mass | PGME<br>30% by mass | - | Polyflow 77 | 3 | 3 |
| Example 14 | Polyimide precursor | DMPU<br>20% by mass | EL<br>40% by mass | PGME<br>40% by mass | - | Polyflow 77 | 3 | 3 |

[Table 2]

| Number | Resin (A) | Organic solvent (B) | Organic solvent (C-1) | Organic solvent (C-2) | Photosensitizer (D) | Other components | Drying property | Step embedding properties |
|---|---|---|---|---|---|---|---|---|
| Example 15 | Polyimide precursor | MDP | EL | PGME | - | Polyflow 77 | 3 | 3 |
| | | 60% by mass | 20% by mass | 20% by mass | | | | |
| Example 16 | Polyimide precursor | MDP | EL | PGME | - | Polyflow 77 | 3 | 3 |
| | | 40% by mass | 30% by mass | 30% by mass | | | | |
| Example 17 | Polyimide precursor | MDP | EL | PGME | - | Polyflow 77 | 3 | 2 |
| | | 20% by mass | 40% by mass | 40% by mass | | | | |
| Example 18 | Polyimide precursor | DVL | EL | PGME | - | Polyflow 77 | 2 | 3 |
| | | 60% by mass | 20% by mass | 20% by mass | | | | |
| Example 19 | Polyimide precursor | DVL | EL | PGME | - | Polyflow 77 | 3 | 3 |
| | | 40% by mass | 30% by mass | 30% by mass | | | | |
| Example 20 | Polyimide precursor | DVL | EL | PGME | - | Polyflow 77 | 3 | 2 |
| | | 20% by mass | 40% by mass | 40% by mass | | | | |
| Example 21 | Polyimide precursor | DMI | EDM | PGME | - | Polyflow 77 | 2 | 3 |
| | | 60% by mass | 20% by mass | 20% by mass | | | | |
| Example 22 | Polyimide precursor | DMI | EDM | PGME | - | Polyflow 77 | 3 | 3 |
| | | 40% by mass | 30% by mass | 30% by mass | | | | |
| Example 23 | Polyimide precursor | DMI | EDM | PGME | - | Polyflow 77 | 3 | 2 |
| | | 20% by mass | 40% by mass | 40% by mass | | | | |

(continued)

| Number | Resin (A) | Organic solvent (B) | Organic solvent (C-1) | Organic solvent (C-2) | Photosensitizer (D) | Other components | Drying property | Step embedding properties |
|---|---|---|---|---|---|---|---|---|
| Example 24 | Polyimide | DMI | EDM | PGME | - | Polyflow 77 | 3 | 3 |
| | | 40% by mass | 30% by mass | 30% by mass | | | | |
| Example 25 | Polybenzoxazole precursor | DMI | EDM | PGME | - | Polyflow 77 | 3 | 3 |
| | | 40% by mass | 30% by mass | 30% by mass | | | | |
| Example 26 | Polyimide precursor | DMPU | EDM | PGME | - | Polyflow 77 | 3 | 3 |
| | | 40% by mass | 30% by mass | 30% by mass | | | | |
| Example 27 | Polyimide precursor | MDP | EDM | PGME | - | Polyflow 77 | 3 | 3 |
| | | 40% by mass | 30% by mass | 30% by mass | | | | |

[Table 3]

| Number | Resin (A) | Organic solvent (B) | Organic solvent (C-1) | Organic solvent (C-2) | Photosensitizer (D) | Other components | Drying property | Step embedding properties |
|---|---|---|---|---|---|---|---|---|
| Example 28 | Polyimide precursor | DVL | EDM | PGME | - | Polyflow 77 | 3 | 3 |
| | | 40% by mass | 30% by mass | 30% by mass | | | | |
| Example 29 | Polyimide precursor | DVL | EL | PGME | Synthesis Example 2 Quinone diazide compound | Polyflow 77 | 3 | 3 |
| | | 40% by mass | 30% by mass | 30% by mass | | | | |
| Example 30 | Polyimide precursor | DVL | EDM | PGME | Synthesis Example 2 Quinone diazide compound | Polyflow 77 | 3 | 3 |
| | | 40% by mass | 30% by mass | 30% by mass | | | | |
| Example 31 | Polyimide | DVL | EL | PGME | Synthesis Example 2 Quinone diazide compound | Polyflow 77 | 3 | 3 |
| | | 40% by mass | 30% by mass | 30% by mass | | | | |
| Example 32 | Polybenzoxazole precursor | DVL | EL | PGME | Synthesis Example 2 Quinone diazide compound | Polyflow 77 | 3 | 3 |
| | | 40% by mass | 30% by mass | 30% by mass | | | | |
| Example 33 | Polyimide precursor | DMI | DMIB | PGME | - | Polyflow 77 | 3 | 3 |
| | | 40% by mass | 30% by mass | 30% by mass | | | | |
| Example 34 | Polyimide precursor | DMPU | DMIB | PGME | - | Polyflow 77 | 3 | 3 |
| | | 40% by mass | 30% by mass | 30% by mass | | | | |
| Example 35 | Polyimide precursor | MDP | DMIB | PGME | - | Polyflow 77 | 3 | 3 |
| | | 40% by mass | 30% by mass | 30% by mass | | | | |
| Example 36 | Polyimide precursor | DVL | DMIB | PGME | - | Polyflow 77 | 3 | 3 |
| | | 40% by mass | 30% by mass | 30% by mass | | | | |

(continued)

| Number | Resin (A) | Organic solvent (B) | Organic solvent (C-1) | Organic solvent (C-2) | Photosensitizer (D) | Other components | Drying property | Step embedding properties |
|---|---|---|---|---|---|---|---|---|
| Example 37 | Polyimide precursor | DMI 40% by mass | GBL 30% by mass | PGME 30% by mass | - | Polyflow 77 | 2 | 3 |
| Example 38 | Polyimide precursor | DMPU 40% by mass | GBL 30% by mass | PGME 30% by mass | - | Polyflow 77 | 2 | 3 |
| Example 39 | Polyimide precursor | MDP 40% by mass | GBL 30% by mass | PGME 30% by mass | - | Polyflow 77 | 2 | 3 |
| Example 40 | Polyimide precursor | DVL 40% by mass | GBL 30% by mass | PGME 30% by mass | - | Polyflow 77 | 2 | 3 |
| Example 41 | Polyimide precursor | DMI 50% by mass | - | PGME 50% by mass | - | Polyflow 77 | 2 | 2 |

[Table 4]

| Number | Resin (A) | Organic solvent (B) | Organic solvent (C-1) | Organic solvent (C-2) | Photosensitizer (D) | Other components | Drying property | Step embedding properties |
|---|---|---|---|---|---|---|---|---|
| Comparative Example 1 | Polyimide precursor | DMI<br>80% by mass | EL<br>10% by mass | PGME<br>10% by mass | - | Polyflow 77 | 1 | 3 |
| Comparative Example 2 | Polyimide precursor | DMPU<br>80% by mass | EL<br>10% by mass | PGME<br>10% by mass | - | Polyflow 77 | 1 | 3 |
| Comparative Example 3 | Polyimide precursor | MDP<br>80% by mass | EL<br>10% by mass | PGME<br>10% by mass | - | Polyflow 77 | 1 | 3 |
| Comparative Example 4 | Polyimide precursor | DVL<br>80% by mass | EL<br>10% by mass | PGME<br>10% by mass | - | Polyflow 77 | 1 | 3 |
| Comparative Example 5 | Polyimide precursor | - | EDM<br>80% by mass | PGME<br>20% by mass | - | Polyflow 77 | 3 | 1 |
| Comparative Example 6 | Polyimide precursor | - | EDM<br>50% by mass | PGME<br>50% by mass | - | Polyflow 77 | 3 | 1 |
| Comparative Example 7 | Polyimide precursor | - | EDM<br>20% by mass | PGME<br>80% by mass | - | Polyflow 77 | 3 | 1 |
| Comparative Example 8 | Polyimide precursor | - | GBL<br>60% by mass<br>EDM<br>20% by mass | PGME<br>20% by mass | - | Polyflow 77 | 2 | 1 |
| Comparative Example 9 | Polyimide precursor | - | GBL<br>40% by mass<br>EDM<br>30% by mass | PGME<br>30% by mass | - | Polyflow 77 | 3 | 1 |

(continued)

| Number | Resin (A) | Organic solvent (B) | Organic solvent (C-1) | Organic solvent (C-2) | Photosensitizer (D) | Other components | Drying property | Step embedding properties |
|---|---|---|---|---|---|---|---|---|
| Comparative Example 10 | Polyimide precursor | - | GBL<br>20% by mass<br>EDM<br>40% by mass | PGME<br>40% by mass | - | Polyflow 77 | 3 | 1 |
| Comparative Example 11 | Polyimide precursor | - | NMP<br>100% by mass | - | - | Polyflow 77 | 2 | 1 |
| Comparative Example 12 | Polyimide precursor | - | GBL<br>100% by mass | - | - | Polyflow 77 | 2 | 1 |

The abbreviations of the organic solvents shown in Tables 1 to 4 have the following meanings.

DMI: 1,3-dimethyl-2-imidazolidinone (boiling point: 220°C)
DMPU: N,N-dimethylpropyleneurea (boiling point: 246°C)
MDP: 3-methoxy-N,N-dimethylpropionamide (boiling point: 216°C)
DVL: delta valerolactone (boiling point: 230°C)
EL: ethyl lactate (boiling point: 154°C)
EDM: diethylene glycol ethyl methyl ether (boiling point: 176°C)
PGME: propylene glycol monomethyl ether (boiling point: 120°C)
DMIB: N,N-dimethylisobutyramide (boiling point: 175°C)
GBL: gamma butyrolactone (boiling point: 203°C)
NMP: N-methyl-2-pyrrolidone (boiling point: 204°C)

DESCRIPTION OF REFERENCE SIGNS

11: semiconductor element
12: surface protective film
13: lead electrode
14: sealing resin
21: silicon wafer
22: Al pad
23: passivation film
24: interlayer insulation film
25: metal (Cr, Ti, etc.) film
26: wire (Al, Cu, etc.)
27: interlayer insulation film
28: barrier metal
29: scribe line
30: solder bump
31: support substrate
32a, 32b, 32c, 32d, 32e, 32f: interlayer insulation film
33a, 33b, 33c, 33d: coil conductor
41: support substrate
42: step part
43: heat-resistant resin film
44: maximum height
45: film thickness of embedded part

## Claims

**1.** A heat-resistant resin composition comprising:

at least one resin selected from the group consisting of a polyimide, a polybenzoxazole, a polyimide precursor, and a polybenzoxazole precursor as a resin (A);
an organic solvent having a boiling point of 210°C or higher and 260°C or lower at atmospheric pressure as an organic solvent (B); and
an organic solvent having a boiling point of 100°C or higher and lower than 210°C at atmospheric pressure as an organic solvent (C),
wherein
a content of the organic solvent (B) is 5% by mass or more and 70% by mass or less with respect to the whole amount of the organic solvents; and
a content of the organic solvent (C) is 30% by mass or more and 95% by mass or less with respect to the whole amount of the organic solvents, and
wherein
the organic solvent (C) contains an organic solvent having a boiling point of 140°C or higher and lower than

210°C at atmospheric pressure as an organic solvent (C-1), and an organic solvent having a boiling point of 100°C or higher and lower than 140°C at atmospheric pressure as an organic solvent (C-2); and
a ratio of a content of the organic solvent (C-1) to a content of the organic solvent (C-2) is 1 : 9 to 9 : 1 by mass ratio.

**2.** The heat-resistant resin composition according to claim 1, wherein the organic solvent (B), the organic solvent (C-1), and the organic solvent (C-2) each have a solubility parameter of 7.0 or more and 13.0 or less.

**3.** The heat-resistant resin composition according to claim 1 or 2, wherein the organic solvent (B) contains at least one organic solvent selected from the group consisting of an organic solvent represented by general formula (1) below, an organic solvent represented by general formula (2) below, and an organic solvent represented by general formula (3) below:

[Chemical Formula 1]

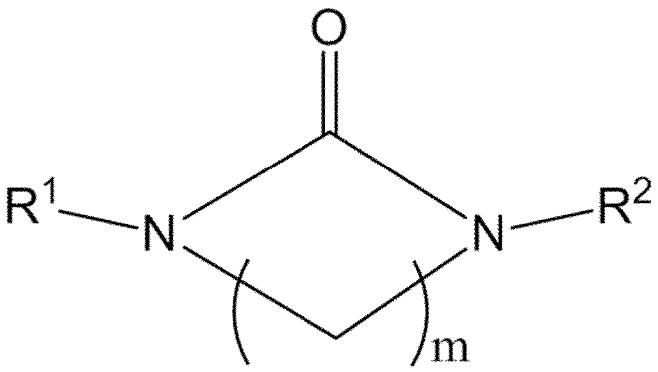

(1)

wherein $R^1$ and $R^2$ may be the same or different from each other, and each represent a monovalent organic group having 1 to 10 carbon atoms; and m represents an integer of 1 to 5;

[Chemical Formula 2]

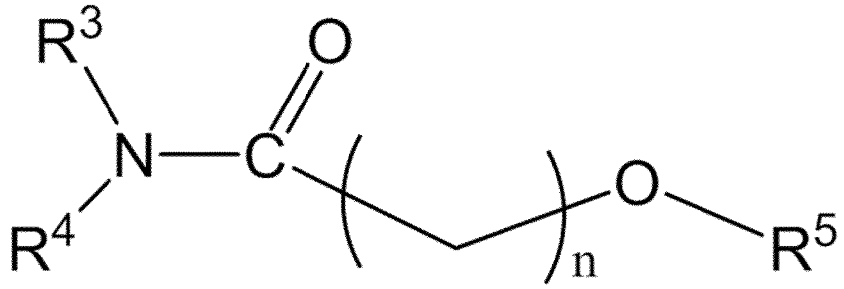

(2)

wherein $R^3$, $R^4$ and $R^5$ may be the same or different from one another, and each represent a monovalent organic group having 1 to 10 carbon atoms; and n represents an integer of 1 to 10; and

[Chemical Formula 3]

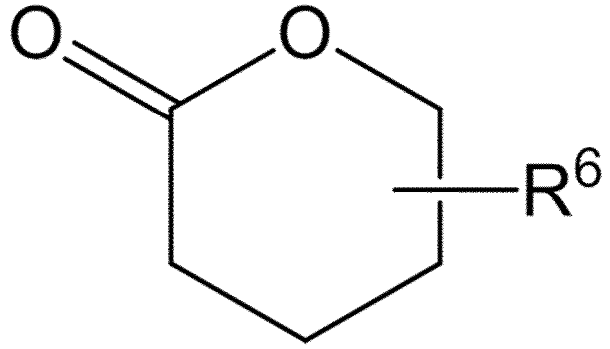

(3)

wherein $R^6$ represents a hydrogen atom or a monovalent organic group having 1 to 10 carbon atoms.

**4.** A method for manufacturing a heat-resistant resin film, the method comprising the steps of:
applying the heat-resistant resin composition according to any one of claims 1 to 3 on a support substrate, drying the heat-resistant resin composition to form a coating film; and heat-treating the coating film.

**5.** A method for manufacturing an interlayer insulation film or a surface protective film, the method comprising the steps of:
applying the heat-resistant resin composition according to any one of claims 1 to 3 on a support substrate, drying the heat-resistant resin composition to form a coating film; and heat-treating the coating film.

**6.** A method for manufacturing an electronic component or a semiconductor component including an interlayer insulation film or a surface protective film obtained by the method for manufacturing an interlayer insulation film or a surface protective film according to claim 5.

**7.** The method for manufacturing an electronic component or a semiconductor component according to claim 6, wherein 2 to 10 interlayer insulation films are used.

**Patentansprüche**

**1.** Wärmebeständige Harzzusammensetzung umfassend:

mindestens ein Harz ausgewählt aus der Gruppe, welche aus einem Polyimid, einem Polybenzoxazol, einem Polyimid-Vorläufer und einem Polybenzoxazol-Vorläufer besteht, als ein Harz (A);
ein organisches Lösungsmittel mit einem Siedepunkt von 210°C oder höher und 260°C oder niedriger bei Atmosphärendruck als ein organisches Lösungsmittel (B); und
ein organisches Lösungsmittel mit einem Siedepunkt von 100°C oder höher und niedriger als 210°C bei Atmosphärendruck als ein organisches Lösungsmittel (C),
wobei
ein Gehalt von dem organischen Lösungsmittel (B) 5 Masse-% oder mehr und 70 Masse-% oder weniger, bezogen auf die Gesamtmenge der organischen Lösungsmittel, beträgt; und
ein Gehalt von dem organischen Lösungsmittel (C) 30 Masse-% oder mehr und 95 Masse-% oder weniger, bezogen auf die Gesamtmenge der organischen Lösungsmittel, beträgt, und
wobei
das organische Lösungsmittel (C) ein organisches Lösungsmittel mit einem Siedepunkt von 140°C oder höher und niedriger als 210°C bei Atmosphärendruck als ein organisches Lösungsmittel (C-1), und ein organisches Lösungsmittel mit einem Siedepunkt von 100°C oder höher und niedriger als 140°C bei Atmosphärendruck als ein organisches Lösungsmittel (C-2) enthält; und
ein Verhältnis von einem Gehalt von dem organischen Lösungsmittel (C-1) zu einem Gehalt von dem organischen Lösungsmittel (C-2) 1 : 9 bis 9 : 1 als Masseverhältnis beträgt.

**2.** Wärmebeständige Harzzusammensetzung gemäß Anspruch 1, wobei das organische Lösungsmittel (B), das organische Lösungsmittel (C-1) und das organische Lösungsmittel (C-2) jeweils einen Löslichkeitsparameter von 7,0 oder höher und 13,0 oder niedriger aufweisen.

**3.** Wärmebeständige Harzzusammensetzung gemäß Anspruch 1 oder 2, wobei das organische Lösungsmittel (B) mindestens ein organisches Lösungsmittel ausgewählt aus der Gruppe, welche aus einem organischen Lösungsmittel, das durch nachstehende allgemeine Formel (1) dargestellt wird, einem organischen Lösungsmittel, das durch nachstehende allgemeine Formel (2) dargestellt wird, und einem organischen Lösungsmittel, das durch nachstehende allgemeine Formel (3) dargestellt wird, besteht, enthält:

[chemische Formel 1]

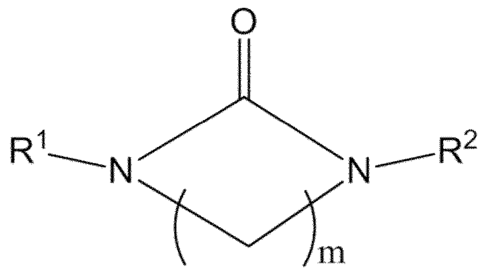

(1)

,

wobei $R^1$ und $R^2$ gleich oder unterschiedlich voneinander sein können, und jeweils einen einwertigen organischen Rest mit 1 bis 10 Kohlenstoffatomen darstellen; und m eine ganze Zahl von 1 bis 5 darstellt;

[chemische Formel 2]

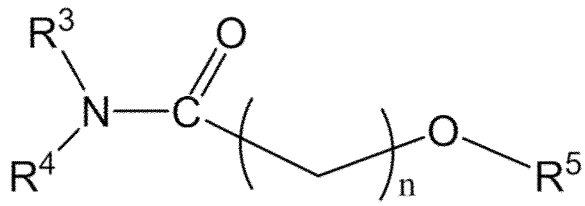

(2)

,

wobei $R^3$, $R^4$ und $R^5$ gleich oder unterschiedlich voneinander sein können, und jeweils einen einwertigen organischen Rest mit 1 bis 10 Kohlenstoffatomen darstellen; und n eine ganze Zahl von 1 bis 10 darstellt; und

[chemische Formel 3]

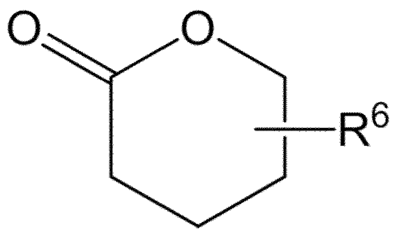

(3)

,

wobei $R^6$ ein Wasserstoffatom oder einen einwertigen organischen Rest mit 1 bis 10 Kohlenstoffatomen darstellt.

**4.** Verfahren zum Herstellen eines wärmebeständigen Harzfilms, wobei das Verfahren die folgenden Schritte umfasst:

Aufbringen der wärmebeständigen Harzzusammensetzung gemäß einem der Ansprüche 1 bis 3 auf ein Trägersubstrat, Trocknen der wärmebeständigen Harzzusammensetzung, um einen Beschichtungsfilm zu bilden; und
Wärmebehandeln des Beschichtungsfilms.

**5.** Verfahren zum Herstellen eines Zwischenschicht-Isolierfilms oder eines Oberflächenschutzfilms, wobei das Verfahren die folgenden Schritte umfasst:

Aufbringen der wärmebeständigen Harzzusammensetzung gemäß einem der Ansprüche 1 bis 3 auf ein Trägersubstrat, Trocknen der wärmebeständigen Harzzusammensetzung, um einen Beschichtungsfilm zu bilden; und
Wärmebehandeln des Beschichtungsfilms.

**6.** Verfahren zum Herstellen einer elektronischen Komponente oder einer Halbleiterkomponente einschließend einen Zwischenschicht-Isolierfilm oder einen Oberflächenschutzfilm, erhalten durch das Verfahren zum Herstellen eines Zwischenschicht-Isolierfilms oder eines Oberflächenschutzfilms gemäß Anspruch 5.

**7.** Verfahren zum Herstellen einer elektronischen Komponente oder einer Halbleiterkomponente gemäß Anspruch 6, wobei 2 bis 10 Zwischenschicht-Isolierfilme verwendet werden.

**Revendications**

**1.** Composition de résine thermorésistante comprenant :

au moins une résine choisie dans le groupe constitué d'un polyimide, d'un polybenzoxazole, d'un précurseur de polyimide et d'un précurseur de polybenzoxazole en tant que résine (A) ;
un solvant organique ayant un point d'ébullition supérieur ou égal à 210°C et inférieur ou égal à 260°C à la pression atmosphérique en tant que solvant organique (B) ; et
un solvant organique ayant un point d'ébullition supérieur ou égal à 100°C et inférieur à 210°C à la pression atmosphérique en tant que solvant organique (C),
dans laquelle
une teneur en solvant organique (B) est supérieure ou égale à 5% en masse et inférieure ou égale à 70% en masse par rapport à la quantité totale des solvants organiques ; et
une teneur en solvant organique (C) est supérieure ou égale à 30% en masse et inférieure ou égale à 95% en masse par rapport à la quantité totale des solvants organiques, et
dans laquelle
le solvant organique (C) contient un solvant organique ayant un point d'ébullition supérieur ou égal à 140°C et inférieur à 210°C à la pression atmosphérique en tant que solvant organique (C-1), et un solvant organique ayant un point d'ébullition supérieur ou égal à 100°C et inférieur à 140°C à la pression atmosphérique en tant que solvant organique (C-2) ; et
un rapport d'une teneur en solvant organique (C-1) sur une teneur en solvant organique (C-2) est de 1 : 9 à 9 : 1 en rapport de masse.

**2.** Composition de résine thermorésistante selon la revendication 1, dans laquelle le solvant organique (B), le solvant organique (C-1) et le solvant organique (C-2) ont chacun un paramètre de solubilité supérieur ou égal à 7,0 et inférieur ou égal à 13,0.

**3.** Composition de résine thermorésistante selon la revendication 1 ou 2, dans laquelle le solvant organique (B) contient au moins un solvant organique choisi dans le groupe constitué d'un solvant organique représenté par la formule générale (1) ci-dessous, d'un solvant organique représenté par la formule générale (2) ci-dessous, et d'un solvant organique représenté par la formule générale (3) ci-dessous :

[Formule chimique 1]

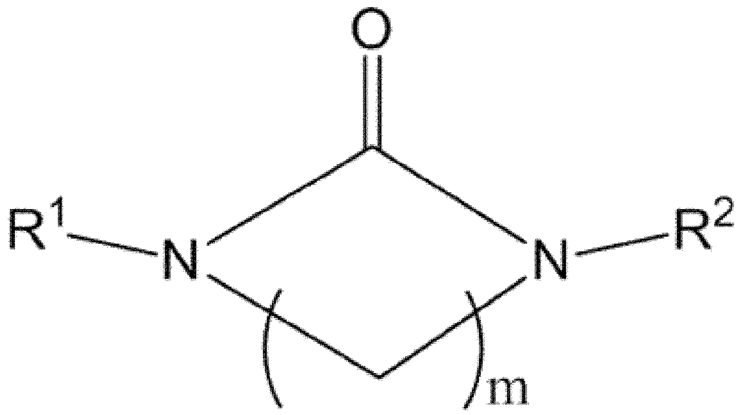

(1)

dans laquelle $R^1$ et $R^2$ peuvent être identiques ou différents l'un de l'autre et représentent chacun un groupe organique monovalent ayant de 1 à 10 atomes de carbone ; et m représente un nombre entier de 1 à 5 ;

[Formule chimique 2]

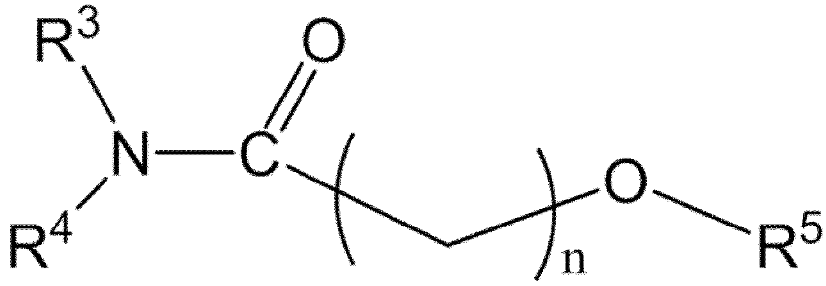

(2)

dans laquelle $R^3$, $R^4$ et $R^5$ peuvent être identiques ou différents les uns des autres, et représentent chacun un groupe organique monovalent ayant 1 à 10 atomes de carbone ; et n représente un nombre entier de 1 à 10 ; et

[Formule chimique 3]

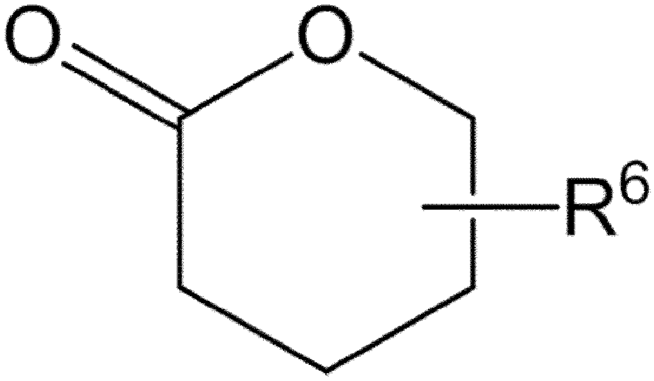

(3)

dans laquelle $R^6$ représente un atome d'hydrogène ou un groupe organique monovalent ayant de 1 à 10 atomes de carbone.

**4.** Procédé de fabrication d'un film de résine thermorésistante, le procédé comprenant les étapes de :
application de la composition de résine thermorésistante selon l'une quelconque des revendications 1 à 3 sur un substrat de support, séchage de la composition de résine thermorésistante pour former un film de revêtement ; et traitement thermique du film de revêtement.

**5.** Procédé de fabrication d'un film isolant intercouche ou d'un film de protection de surface, le procédé comprenant

les étapes de :
application de la composition de résine thermorésistante selon l'une quelconque des revendications 1 à 3 sur un substrat de support, séchage de la composition de résine thermorésistante pour former un film de revêtement ; et traitement thermique du film de revêtement.

**6.** Procédé de fabrication d'un composant électronique ou d'un composant semi-conducteur comprenant un film isolant intercouche ou un film de protection de surface obtenu par le procédé de fabrication d'un film isolant intercouche ou d'un film de protection de surface selon la revendication 5.

**7.** Procédé de fabrication d'un composant électronique ou d'un composant semi-conducteur selon la revendication 6, dans lequel 2 à 10 films isolants intercouches sont utilisés.

[Fig 1]

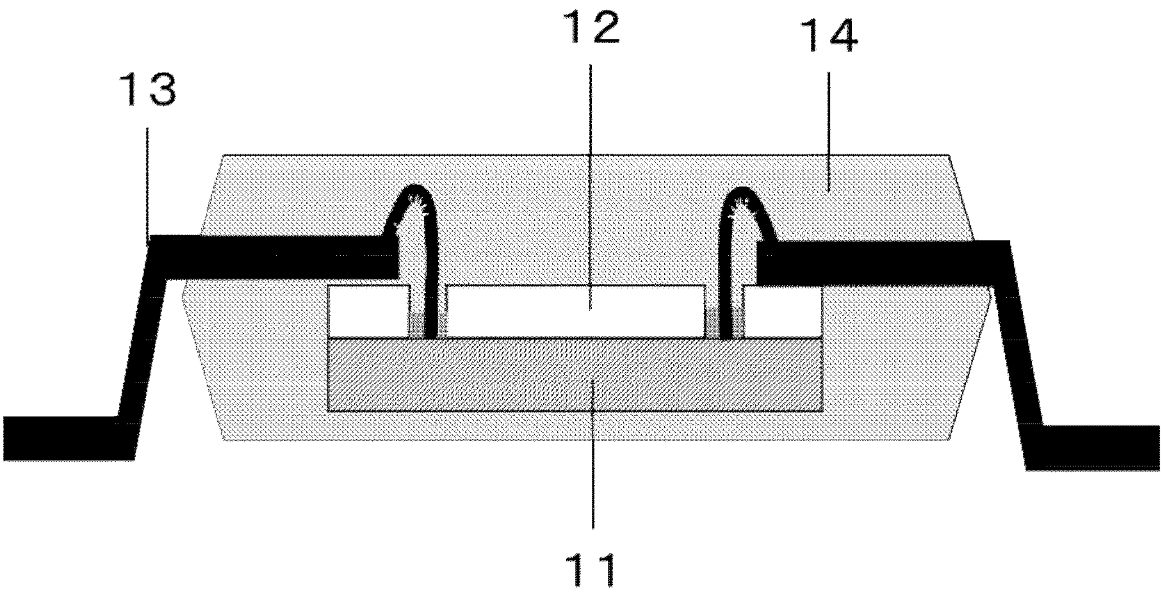

[Fig 2]

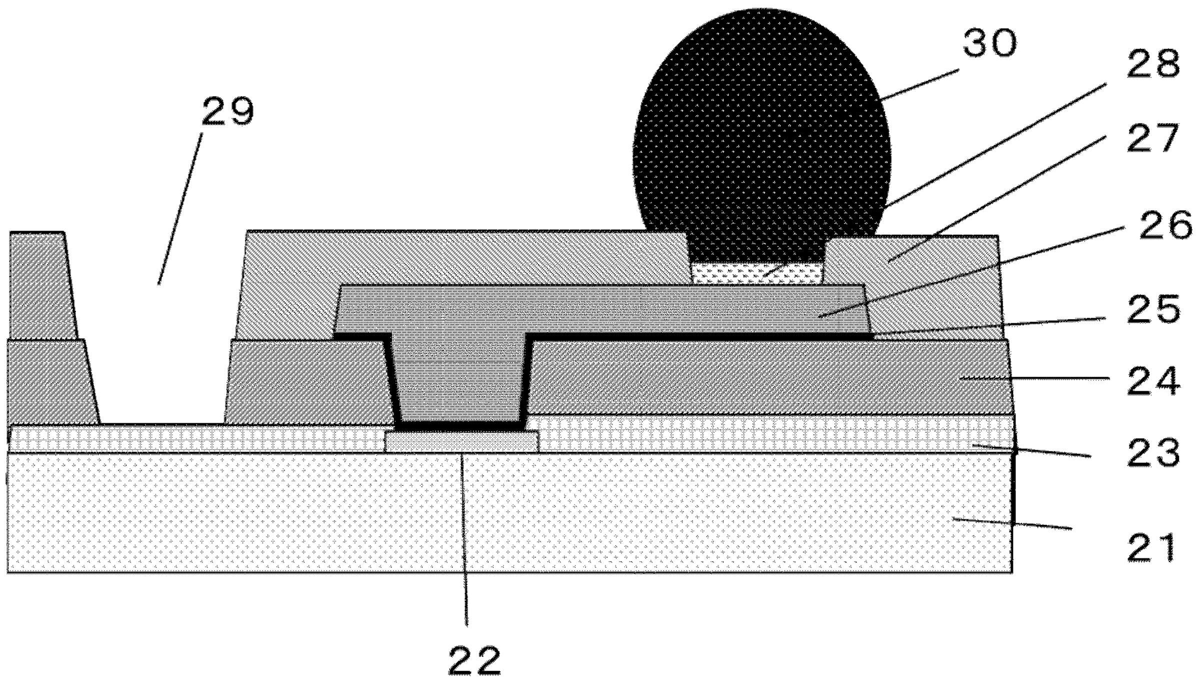

[Fig 3]

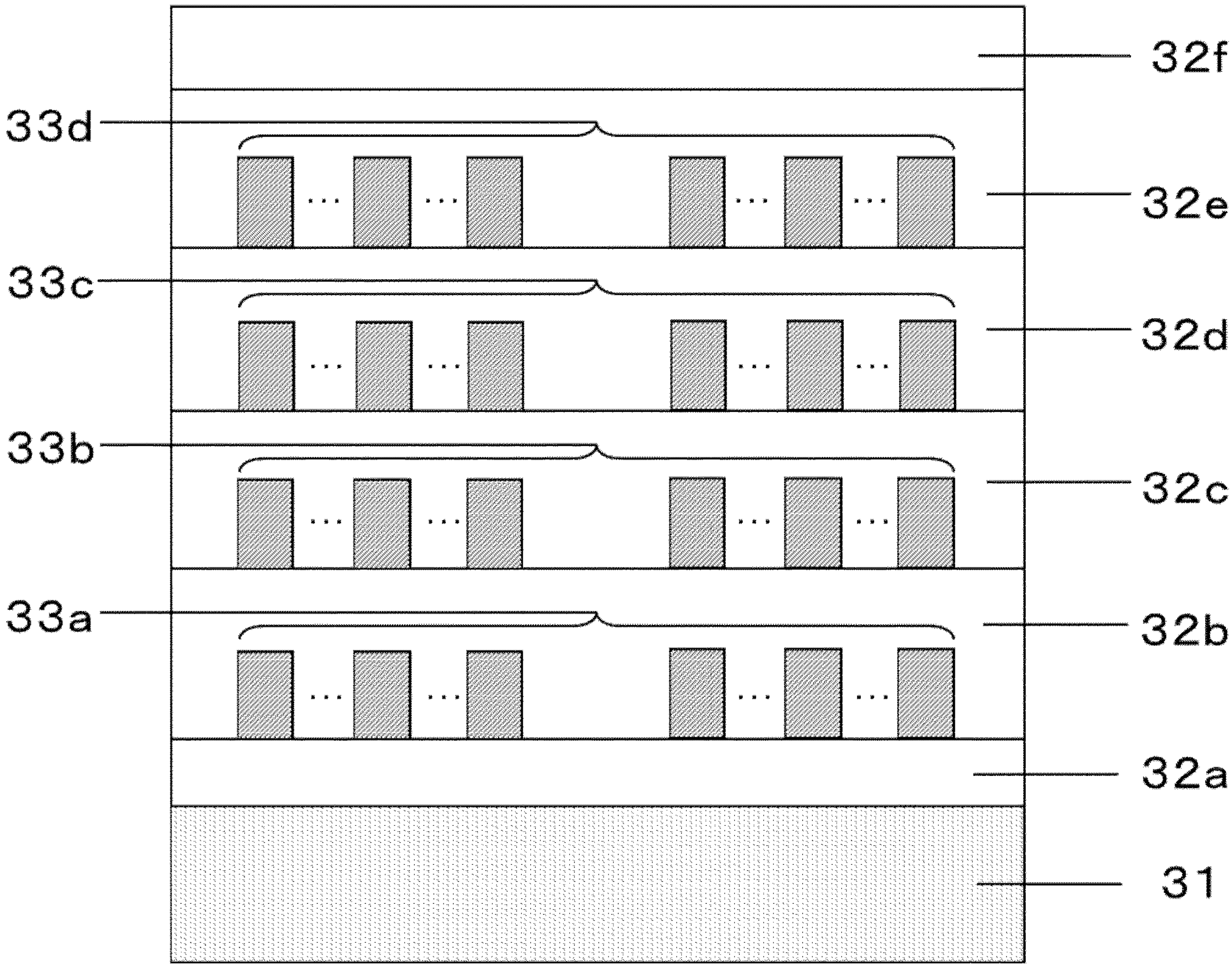

[Fig 4]

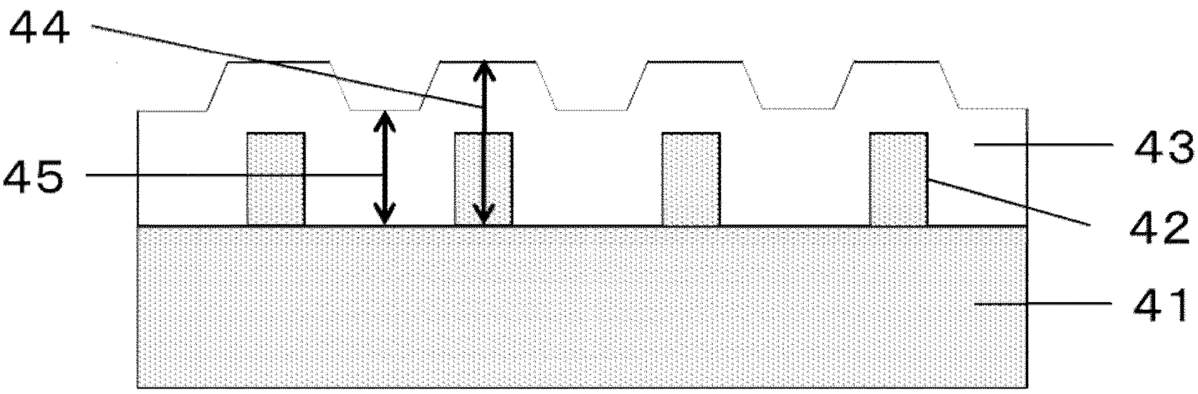

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2008186990 A
- WO 2010047264 A
- WO 20110300744 A
- JP 2014162818 A
- JP 2002327060 A
- WO 2012090827 A1
- JP 2010155895 A
- JP 2014132057 A
- WO 2009038205 A1

### Non-patent literature cited in the description

- **YUJI HARASAKI ; MAKI SHOTEN.** *Basic Science of Coating,* 65
- **YUJI HARASAKI ; MAKI SHOTEN.** *Basic Science of Coating,* 55